# EUROPEAN PATENT APPLICATION

(11) **EP 4 669 083 A1**
(43) Date of publication of application: **24.12.2025**
(21) Application number: 25183379.4
(22) Date of filing: 17.06.2025
(51) Int. Cl.: H10K 59/80, H10K 59/88

(54) **DISPLAY DEVICE, ELECTRONIC DEVICE INCLUDING THE SAME, AND METHOD FOR MANUFACTURING THE SAME**

(30) Priority: 17.06.2024 KR 20240078233
(71) Applicant: Samsung Display Co., Ltd, Yongin-City, Gyeonggi-do 17113 (KR)
(72) Inventor: SUNG, Woo Yong, Yongin-si (KR); SONG, Seung Yong, Yongin-si (KR); YANG, Hee Jun, Yongin-si (KR); LEE, Jeong Seok, Yongin-si (KR)
(74) Representative: Marks & Clerk LLP

(57) **Abstract**

A display device includes a substrate including a display area in which light emitting areas are arranged; a circuit layer disposed on the substrate; an element layer disposed on the circuit layer; and a sealing layer disposed on the element layer. The sealing layer includes a first sealing layer disposed on the element layer and including an inorganic insulating material; a second sealing layer disposed on the first sealing layer and including an organic insulating material; concave grooves defined in a non-light emitting area between the light emitting areas and recessed through at least a portion of the second sealing layer; and a third sealing layer covering the second sealing layer and the concave grooves and including an inorganic insulating material.

## Description

### BACKGROUND

### 1. Technical Field

The present disclosure relates to a display device, an electronic device including the same, and a method for manufacturing the same.

### 2. Description of the Related Art

As an information society develops, the demand for a display device for displaying an image is increasing in various forms. For example, the display device has been applied to various electronic devices such as smartphones, digital cameras, laptop computers, navigation devices, and smart televisions.

The display device may be a flat panel display device such as a liquid crystal display device, a field emission display device, or a light emitting display device. Here, the light emitting display device may include an organic light emitting display device including an organic light emitting element, an inorganic light emitting display device including an inorganic light emitting element such as an inorganic semiconductor, and a micro or nano light emitting display device including a micro or nano light emitting element.

The organic light emitting display device displays an image using light emitting elements each including a light emitting layer made of an organic light emitting material. As such, as the organic light emitting display device implements image display using self-light emitting elements, the organic light emitting display device may have relatively superior performance in terms of power consumption, response speed, emission efficiency, luminance, and wide viewing angle compared to other display devices.

A display surface of the display device from which light is emitted may include a display area where an image is displayed and a non-display area surrounding the display area. Light emitting areas that emit light with respective luminance and color may be arranged in the display area.

### SUMMARY

During the process of manufacturing and using the display device, external shock may be applied to the display device due to situations such as collision with other objects or the device being dropped. If such external shock exceeds a critical value, the display device may be easily deformed or broken, which may reduce the lifespan and convenience of the display device.

In addition, when the display device is deformed by being folded, bent, or rolled, the display device may become more vulnerable to the external shock because bending stress is applied to a folded, bent, or rolled portion.

Aspects of the present disclosure provide a display device whose elasticity may be improved so that external shock may be mitigated or shock transmission may be reduced, an electronic device including the same, and a method for manufacturing the display device.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to an aspect of the present disclosure, a display device includes a substrate including a display area in which light emitting areas are arranged; a circuit layer disposed on the substrate; an element layer disposed on the circuit layer; and a sealing layer disposed on the element layer. The sealing layer includes a first sealing layer disposed on the element layer and including an inorganic insulating material; a second sealing layer disposed on the first sealing layer and including an organic insulating material; concave grooves defined in a non-light emitting area between the light emitting areas and recessed through at least a portion of the second sealing layer; and a third sealing layer covering the second sealing layer and the concave grooves and including an inorganic insulating material.

The element layer may include anode electrodes disposed in the light emitting areas; a pixel defining layer disposed in the non-light emitting area and covering edges of the anode electrodes; a cathode auxiliary electrode disposed on the pixel defining layer; first common layers disposed on the anode electrodes; light emitting layers disposed on the first common layers; second common layers disposed on the light emitting layers; and cathode electrodes disposed on the second common layers. The pixel defining layer may include an inorganic insulating material. Edges of the cathode electrodes may be in contact with the cathode auxiliary electrode.

The cathode auxiliary electrode may include a main layer; and a roof layer disposed on the main layer and including a metal material different from a material of the main layer. An undercut portion may be defined by a bottom surface of the roof layer and a side surface of the man layer, overlap a corresponding cathode electrode among the cathode electrodes and have a shape in which an edge of the roof layer more protrudes than the main layer.

The cathode auxiliary electrode may further include a bottom layer disposed below the main layer and including a different metal material from the material of the main layer.

The element layer may further include a dummy common portion disposed on the pixel defining layer, including the same material as the second common layers, and spaced apart from the second common layers by the undercut portion; and a dummy cathode portion covering the dummy common portion, including the same material as the cathode electrodes, and spaced apart from the cathode electrodes by the undercut portion. The first sealing layer may cover the cathode electrodes and the dummy cathode portion and is in contact with the cathode auxiliary electrode.

The side surface of the main layer may include a first junction portion in contact with a corresponding edge of the second common layers; a second junction portion in contact with a corresponding edge of the edges of the cathode electrodes; and a third junction portion in contact with the first sealing layer.

The concave grooves may overlap the dummy cathode portion. At least some of the concave grooves may be spaced apart from the first sealing layer.

The concave grooves may overlap the dummy cathode portion. At least some of the concave grooves may penetrate the second sealing layer.

The third sealing layer may be in contact with the first sealing layer through the concave grooves.

Each of the concave grooves may extend in one of a first direction and a second direction in which the light emitting areas are arranged.

Each of the concave grooves may include a bent shape in which first extension portions extending in a first diagonal direction intersecting the first direction and the second direction, and second extension portions extending in a second diagonal direction intersecting the first direction, the second direction, and the first diagonal direction may be alternately arranged in the first direction or the second direction.

The concave grooves may include first extension grooves and second extension grooves, which intersect each other.

The substrate may further include a non-display area disposed around the display area. The non-display area may include a junction area surrounding the display area. The second sealing layer may be disposed in an area surrounded by the junction area. In the junction area, the third sealing layer may be in contact with the first sealing layer.

The display device may further include an overcoat layer disposed on the third sealing layer, including an organic insulating material, and filling the concave grooves.

According to an aspect of the present disclosure, an electronic device includes a display device providing a screen. The display device includes a substrate including a display area in which light emitting areas are arranged, and a non-display area disposed around the display area; a circuit layer disposed on the substrate; an element layer disposed on the circuit layer; and a sealing layer disposed on the element layer. The sealing layer includes a first sealing layer disposed on the element layer and including an inorganic insulating material; a second sealing layer disposed on the first sealing layer and including an organic insulating material; concave grooves defined in a non-light emitting area between the light emitting areas and recessed through at least a portion of the second sealing layer; and a third sealing layer covering the second sealing layer and the concave grooves and including an inorganic insulating material. The non-display area includes a junction area surrounding the display area. The second sealing layer is disposed in an area surrounded by the junction area. In the junction area, the third sealing layer is in contact with the first sealing layer.

Each of the concave grooves may extend in one of a first direction and a second direction in which the light emitting areas are arranged.

Each of the concave grooves may include a bent shape in which first extension portions extending in a first diagonal direction intersecting the first direction and the second direction, and second extension portions extending in a second diagonal direction intersecting the first direction, the second direction, and the first diagonal direction are alternately arranged in the first direction or the second direction.

The concave grooves may include first extension grooves and second extension grooves, which intersect each other.

The element layer may further include anode electrodes disposed in the light emitting areas; a pixel defining layer disposed in the non-light emitting area and covering edges of the anode electrodes; a cathode auxiliary electrode disposed on the pixel defining layer; first common layers disposed on the anode electrodes; light emitting layers disposed on the first common layers; second common layers disposed on the light emitting layers; and cathode electrodes disposed on the second common layers. The pixel defining layer may include an inorganic insulating material. Edges of the cathode electrodes may be in contact with the cathode auxiliary electrode. The cathode auxiliary electrode may include a main layer; and a roof layer disposed on the main layer and including a metal material different from a material of the main layer. An undercut portion may be defined by a bottom surface of the roof layer and a side surface of the man layer, overlaps a corresponding cathode electrode and have a shape in which an edge of the roof layer more protrudes than the main layer.

The cathode auxiliary electrode may further include a bottom layer disposed below the main layer and including a different metal material from the material of the main layer.

The element layer may further include a dummy common portion disposed on the pixel defining layer, including the same material as the second common layers, and spaced apart from the second common layers by the undercut portion; and a dummy cathode portion covering the dummy common portion, including the same material as the cathode electrodes, and spaced apart from the cathode electrodes by the undercut portion. The first sealing layer may cover the cathode electrodes and the dummy cathode portion and be in contact with the cathode auxiliary electrode. The side surface of the main layer may include a first junction portion in contact with a corresponding edge of the second common layers; a second junction portion in contact with a corresponding edge of the edges of the cathode electrodes; and a third junction portion in contact with the first sealing layer.

The concave grooves may overlap the dummy cathode portion. At least some of the concave grooves may be spaced apart from the first sealing layer.

The concave grooves may overlap the dummy cathode portion. At least some of the concave grooves may penetrate the second sealing layer. The third sealing layer may be in contact with the first sealing layer through the concave grooves.

The display device may further include an overcoat layer disposed on the third sealing layer, including an organic insulating material, and filling the concave grooves.

According to an aspect of the present disclosure, a method for manufacturing a display device, includes preparing a substrate; disposing a circuit layer on the substrate; disposing an element layer on the circuit layer; and disposing a sealing layer on the element layer. The substrate includes a display area in which light emitting areas are arranged, and a non-display area disposed around the display area. The non-display area includes a junction area surrounding the display area. The disposing of the sealing layer includes Disposing a first sealing layer including an inorganic insulating material on the element layer; disposing a second sealing layer including an organic insulating material on the first sealing layer; forming concave grooves recessed through at least a portion of the second sealing layer in a non-light emitting area between the light emitting areas; and disposing a third sealing layer covering the second sealing layer and the concave grooves and including an inorganic insulating material.

The forming of the concave grooves may include sequentially disposing a first mask material layer including a metal material and a second mask material layer including a photoresist material on the second sealing layer; forming a first mask layer including a first opening facing the junction area, first blocking portions arranged in the non-light emitting area, and a second blocking portion that is thicker than the first blocking portions in the non-light emitting area, by partially removing the second mask material layer; forming a second mask layer including a second opening by removing a portion of the first mask material layer exposed by the first opening; removing a portion of the second sealing layer exposed by the second opening; forming a third mask layer including third openings by removing the first blocking portions of the first mask layer; forming a fourth mask layer including fourth openings by removing a portion of the second mask layer exposed by the third openings; forming the concave grooves by partially removing the second sealing layer exposed by the fourth openings; and removing the third mask layer and the fourth mask layer.

In the disposing of the element layer, the element layer may include anode electrodes disposed in the light emitting areas; a pixel defining layer disposed in the non-light emitting area and covering edges of the anode electrodes; a cathode auxiliary electrode disposed on the pixel defining layer; first common layers disposed on the anode electrodes; light emitting layers disposed on the first common layers; second common layers disposed on the light emitting layers; and cathode electrodes disposed on the second common layers. The cathode auxiliary electrode may include a main layer; and a roof layer disposed on the main layer and including a metal material different from a material of the main layer. An undercut portion may be defined by a bottom surface of the roof layer and a side surface of the man layer, overlaps a corresponding cathode electrode and have a shape in which an edge of the roof layer more protrudes than the main layer.

In the disposing of the element layer, the element layer may further include a dummy common portion disposed on the pixel defining layer, including the same material as the second common layers and spaced apart from the second common layers by the undercut portion; and a dummy cathode portion covering the dummy common portion, , including the same material as the cathode electrodes, and spaced apart from the cathode electrodes by the undercut portion. The side surface of the main layer may be in contact with a corresponding edge of the second common layers and a corresponding edge of the cathode electrodes. In the disposing of the first sealing layer, the first sealing layer may cover the cathode electrodes and the dummy cathode portion and be in contact with the side surface of the main layer of the cathode auxiliary electrode.

In the forming of the concave grooves, at least some of the concave grooves may be spaced apart from the first sealing layer.

In the forming of the concave grooves, at least some of the concave grooves may penetrate the second sealing layer. In the disposing of the third sealing layer, the third sealing layer may be in contact with the first sealing layer through the at least some of the concave grooves and is in contact with the first sealing layer in the junction area.

The sealing layer of the display device according to the embodiments may include a first sealing layer disposed on an element layer and including an inorganic insulating material, a second sealing layer disposed on the first sealing layer and including an organic insulating material, concave grooves formed in a non-light emitting area recessed through at least a portion of the second sealing layer; and a third sealing layer covering the second sealing layer and the concave grooves and including an inorganic insulating material.

In this way, since the light emitting areas may be protected by the second sealing layer, while a surface area of the third sealing layer may be increased compared to a surface area of the second sealing layer by the concave grooves of the non-light-emitting areas, the flexibility of the third sealing layer may be effectively increased.

As a result, since the flexibility of the display device may be increased, stress caused by external shock or shape deformation may be alleviated and the range of diffusion to the surroundings may be reduced. Therefore, the lifespan and convenience of the display device may be effectively improved.

According to the embodiments, the element layer of the display device may include anode electrodes disposed in the light emitting areas, a pixel defining layer disposed in the non-emitting area and covering edges of the anode electrodes, a cathode auxiliary electrode disposed on the pixel defining layer, first common layers disposed on the anode electrodes, light emitting layers disposed on the first common layers, second common layers disposed on the light emitting layers, and cathode electrodes disposed on the second common layers. The pixel defining layer may include an inorganic insulating material. In addition, edges of the cathode electrodes may be in contact with the cathode auxiliary electrode.

As a result, the element layer may include light emitting elements disposed in each light emitting area and having a structure in which the first common layer, the light emitting layer, and the second common layer are interposed between the anode electrode and the cathode electrode.

The cathode auxiliary electrode may include a main layer, a roof layer disposed on the main layer and including a metal material different from the main layer, and an undercut portion overlapping the anode electrodes and having a shape in which an edge of the roof layer more protrudes than the main layer.

The element layer may further include a dummy common portion disposed on the same layer as the second common layers on the pixel defining layer and spaced apart from the second common layers by the undercut portion, and a dummy cathode portion covering a dummy common layer, disposed on the same layer as the cathode electrodes, and spaced apart from the cathode electrodes by the undercut portion.

The first sealing layer may cover the cathode electrodes and the dummy cathode portion and may be in contact with the cathode auxiliary electrode.

That is, a side surface of the main layer of the cathode auxiliary electrode may include a first junction portion in contact with edges of the second common portions, a second junction portion in contact with the edges of the cathode electrodes, and a third junction portion in contact with the first sealing layer.

In this way, the light emitting elements each disposed in the light emitting areas may be individually sealed by the inorganic junction between the cathode auxiliary electrode and the first sealing layer, which make it difficult for oxygen or moisture to permeate through the light emitting elements. As a result, the display device according to the embodiments may improve flexibility by the concave grooves, while preventing rapid deterioration of the light emitting elements due to permeation of oxygen or moisture.

However, the effects of the embodiments are not restricted to the one set forth herein. The above and other effects of the embodiments will become more apparent to one of daily skill in the art to which the embodiments pertain by referencing the claims.

At least some of the above and other features of the invention are set out in the claims.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating a display device according to embodiments;
FIG. 2 is a plan view illustrating the display device of FIG. 1;
FIG. 3 is a cross-sectional view taken along line A-A' of FIG. 2;
FIG. 4 is a layout view illustrating portion B of FIG. 2;
FIG. 5 is an equivalent circuit diagram illustrating a light emitting pixel driver of FIG. 4 according to an embodiment;
FIGS. 6 and 7 are layout views illustrating portion B of FIG. 2 according to embodiments;
FIG. 8 is a cross-sectional view taken along line D-D' of FIG. 6;
FIG. 9 is a cross-sectional view taken along line C-C' of FIG. 2 according to the embodiment of FIG. 6;
FIG. 10 is a layout view illustrating portion B of FIG. 2 according to an embodiment;
FIGS. 11 and 12 are cross-sectional views taken along line D-D' of FIG. 6 according to embodiments;
FIG. 13 is a flowchart illustrating a method for manufacturing a display device according to embodiments;
FIG. 14 is a flowchart illustrating a step of forming concave grooves of FIG. 13; and
FIGS. 15, 16, 17, 18, 19, 20, 21, 22, 23, 24 and 25 are process views illustrating some steps of the flowcharts of FIGS. 13 and 14.

### DETAILED DESCRIPTION

The embodiments will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity.

Some of the parts which are not associated with the description may not be provided in order to describe embodiments of the disclosure.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

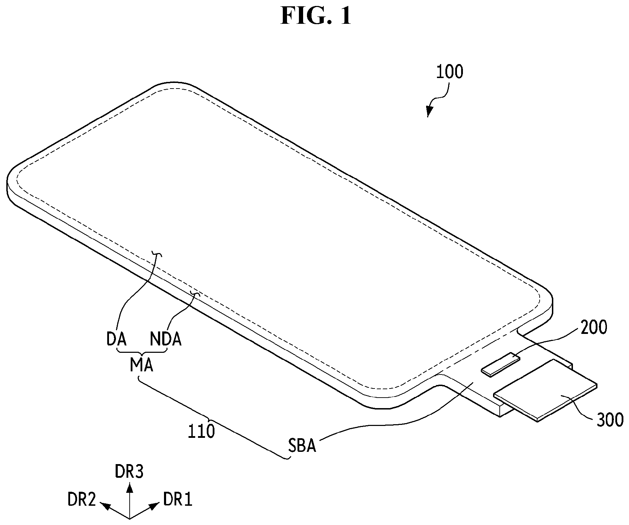

Further, the phrase "in a plan view" means when an object portion is viewed in a thickness direction (i.e., third direction DR3) of the display device 100 (See FIG. 1), and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 10%, 5% of the stated value.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, embodiments will be described with reference to the accompanying drawings.

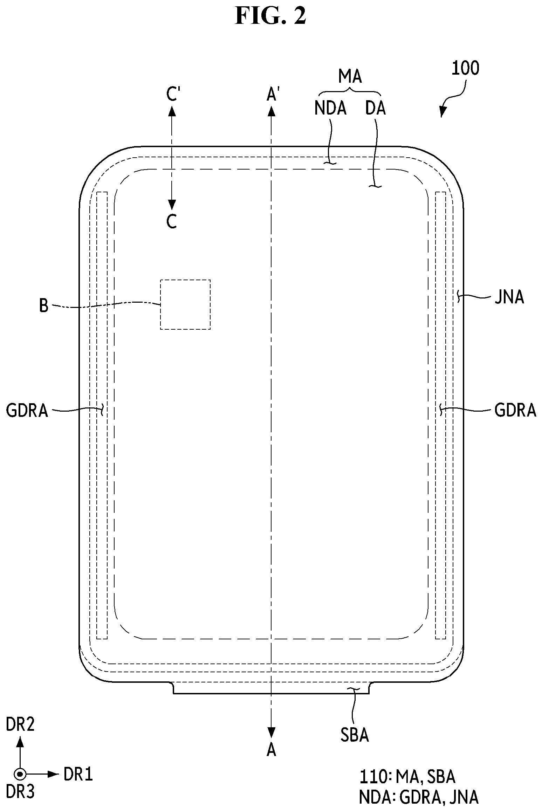

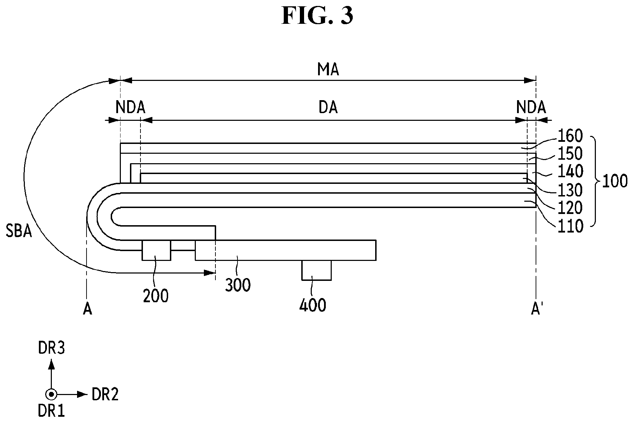

FIG. 1 is a perspective view illustrating a display device according to embodiments. FIG. 2 is a plan view illustrating the display device of FIG. 1. FIG. 3 is a cross-sectional view taken along line A-A' of FIG. 2.

Referring to FIGS. 1 and 2, a display device 100 according to embodiments is a device that displays a moving image or a still image, and may be used as a display screen of each of various products such as televisions, laptop computers, monitors, billboards, and Internet of Things (IOT) as well as portable electronic devices such as mobile phones, smartphones, tablet personal computers (PCs), smartwatches, watch phones, mobile communication terminals, electronic organizers, electronic books, portable multimedia players (PMPs), navigation devices, and ultra mobile PCs (UMPCs).

The display device 100 may be a light emitting display device such as an organic light emitting display device using an organic light emitting diode, a quantum dot light emitting display device including a quantum dot light emitting layer, an inorganic light emitting display device including an inorganic semiconductor, and a micro light emitting display device using a micro or nano light emitting diode (micro or nano LED). Hereinafter, the description will be mainly made based on the assumption that the display device 100 is an organic light emitting display device. However, the present disclosure is not limited thereto and may be applied to display devices including organic insulating materials, organic light emitting materials, and metal materials.

The display device 100 may be formed to be flat, but is not limited thereto. For example, the display device 100 may include curved surface portions formed at left and right distal ends thereof and having a constant curvature or a variable curvature. In addition, the display device 100 may be flexibly formed to be curved, bent, folded, or rolled.

As illustrated in FIGS. 1, 2, and 3, the display device 100 according to the embodiments may include a substrate 110.

The substrate 110 may include a main area MA corresponding to a display surface of the display device 100 and a sub-area SBA protruding from a portion of one side of the main area MA.

The display device 100 may include a display driving circuit 200 disposed in the sub-area SBA and a display circuit board 300 bonded to one side of the sub-area SBA.

As illustrated in FIG. 2, the main area MA may include a display area DA disposed at most of the center and a non-display area NDA disposed around the display area DA.

The display area DA may be formed in a rectangular plane having short sides extending in a first direction DR1 and long sides extending in a second direction DR2 intersecting the first direction DR1. A corner where the short side in the first direction DR1 and the long side in the second direction DR2 meet may be rounded to have a predetermined curvature or may be formed at a right angle. The planar shape of the display area DA is not limited to the quadrangular shape, and the display area DA may be formed in other polygonal, circular, or oval shapes. The first direction DR1, the second direction DR2, and the third direction DR3 may be perpendicular to one another.

The non-display area NDA may be disposed at an edge of the main area MA to surround the display area DA.

The non-display area NDA may include a gate driving circuit area GDRA facing one side of the display area DA.

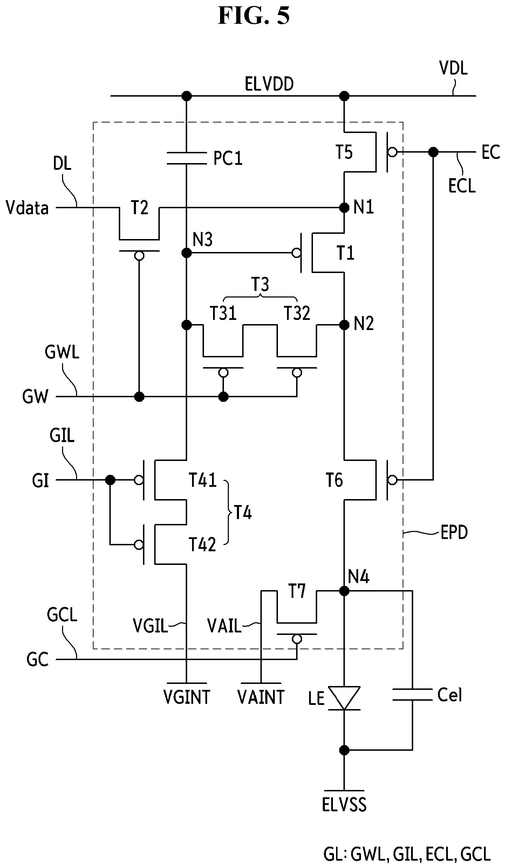

A circuit layer (120 in FIG. 3) of the display device 100 according to the embodiments may include a gate driving circuit disposed in the gate driving circuit area GDRA and electrically connected to gate lines (GL in FIG. 5).

According to embodiments, the non-display area NDA may further include a junction area JNA surrounding a periphery of the display area DA.

In the junction area JNA, a structure may be provided in which inorganic insulating materials of a sealing layer (140 in FIG. 3) come into contact with inorganic insulating materials of the circuit layer (120 in FIG. 3).

FIGS. 2 and 3 illustrate the display device 100 with a portion of the sub-area SBA curved.

As illustrated in FIGS. 2 and 3, as a portion of the sub-area SBA is deformed into a curved shape, another portion of the sub-area SBA may be disposed on a rear surface of the display device 100.

Referring to FIG. 3, the display device 100 according to the embodiments includes a substrate 110, a circuit layer 120 disposed on the substrate 110, and an element layer 130 disposed on the circuit layer 120.

The display device 100 according to the embodiments may further include a sealing layer 140 disposed on the element layer 130, and a touch sensor layer 150 disposed on the sealing layer 140.

In addition, the display device 100 according to the embodiments may further include a polarizing layer 160 disposed on the touch sensor layer 150 to reduce reflection of external light.

The substrate 110 may be made of an insulating material such as a polymer resin. For example, the substrate 110 may be made of polyimide. The substrate 110 may be a flexible substrate that may be bent, folded, and rolled.

Alternatively, the substrate 110 may be made of an insulating material such as glass.

The substrate 110 may include a main area MA and a sub-area SBA. The main area MA may include a display area DA and a non-display area NDA.

The display device 100 may further include a display driving circuit 200 disposed in the sub-area SBA, a display circuit board 300 bonded to one side of the sub-area SBA, and a touch driving circuit 400 mounted on the display circuit board 300.

The display driving circuit 200 may supply data signals (Vdata in FIG. 5) to data lines (DL in FIG. 5) of the circuit layer 120.

The display circuit board 300 may be connected to signal pads disposed at the edge of the sub-area SBA and may be electrically connected to the circuit layer 120 or the display driving circuit 200.

The touch driving circuit 400 may be electrically connected to the touch sensor layer 150.

The circuit layer 120 may include insulating layers, conductive layers, and one or more semiconductor layers. One or more insulating layers may be interposed between the conductive layers and the one or more semiconductor layers. The circuit layer 120 may include transistors formed with one or more semiconductor layers and one or more conductive layers, and signal lines each formed with at least one of the conductive layers.

The element layer 130 may include light emitting elements.

The sealing layer 140 may cover the circuit layer 120 and the element layer 130 and may block permeation of oxygen or moisture into the element layer 130.

The touch sensor layer 150 may include touch electrodes and touch lines connected thereto.

The touch driving circuit 400 may apply a touch driving signal to driving lines of the touch sensor layer 150 and receive a touch sensing signal from sensing lines. In addition, the touch driving circuit 400 may determine whether a user has touched or has approached to the touch sensor layer by sensing changes in charge of electrostatic capacitances based on the touch sensing signal. The user's touch indicates that a user's finger or an object such as a pen comes into direct contact with an upper surface of a cover window disposed on the touch sensor layer. The user's approach indicates that the user's finger or the object such as the pen hovers above the upper surface of the cover window. The touch driving circuit 400 may output touch data including the user's touch coordinates to a main processor.

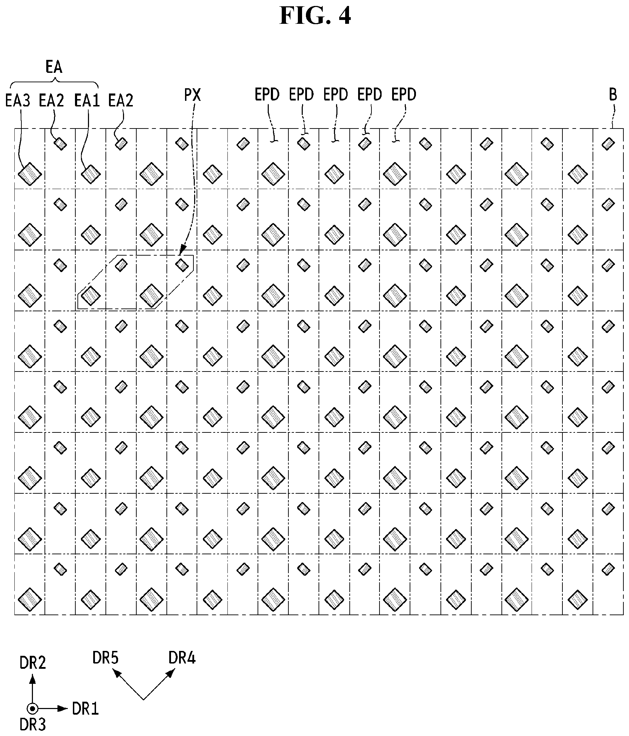

FIG. 4 is a layout view illustrating portion B of FIG. 2.

Referring to FIG. 4, the display area DA of the display device 100 according to embodiments may include light emitting areas EA. In addition, the display area DA may further include a non-light emitting area disposed in a spaced portion between the light emitting areas EA.

The element layer (130 in FIG. 3) may include light emitting elements (LE in FIG. 5) each disposed in the light emitting areas EA.

The circuit layer (120 in FIG. 3) may include light emitting pixel drivers EPD arranged to be parallel to each other in the first direction DR1 and the second direction DR2 in the main area MA. The light emitting pixel drivers EPD may be electrically connected to the light emitting element (LE in FIG. 5) of the element layer 130, respectively.

The light emitting areas EA may have a rhombic planar shape or a rectangular planar shape. However, this is only an example, and the planar shape of the light emitting areas EA according to an embodiment is not limited to that illustrated in FIG. 4. That is, the light emitting areas EA may have a polygonal planar shape such as a square, pentagon, or hexagon, or a circular or oval planar shape including curved edges.

The light emitting areas EA may include first light emitting areas EA1 that emit light of a first color in a predetermined wavelength band, second light emitting areas EA2 that emit light of a second color in a wavelength band lower than that of the first color, and third light emitting areas EA3 that emit light of a third color in a wavelength band lower than that of the second color.

As an example, the first color may be red in a wavelength band of approximately 600 nm to 750 nm. The second color may be green in a wavelength band of approximately 480 nm to 560 nm. The third color may be blue in a wavelength band of approximately 370 nm to 460 nm.

The first light emitting areas EA1 and the third light emitting areas EA3 may be alternately disposed in at least one of the first direction DR1 and the second direction DR2.

The second light emitting areas EA2 may be arranged to be parallel to each other in at least one of the first direction DR1 and the second direction DR2.

In addition, the second light emitting areas EA2 may be adjacent to the first light emitting areas EA1 and the third light emitting areas EA3 in diagonal directions DR4 and DR5 intersecting the first and second directions DR1 and DR2.

Pixels PX that display each luminance and color may be provided by the first light emitting area EA1, the second light emitting area EA2, and the third light emitting area EA3 adjacent to each other among the light emitting areas EA.

In other words, the pixels PX may be basic units that display various colors, including white, at predetermined luminance.

Each of the pixels PX may include at least one first light emitting area EA1, at least one second light emitting area EA2, and at least one third light emitting area EA3 adjacent to each other. Accordingly, each of the pixels PX may display various colors through mixing of light emitted from the first, second, and third light emitting areas EA1, EA2, and EA3 adjacent to each other.

FIG. 5 is an equivalent circuit diagram illustrating a light emitting pixel driver of FIG. 4 according to an embodiment.

Referring to FIG. 5, the light emitting pixel drivers EPD of the circuit layer 120 may be electrically connected between a first power ELVDD and the light emitting elements LE of the element layer 130.

One of the light emitting elements LE of the element layer 130 may be electrically connected between one of the light emitting pixel driver EPD of the circuit layer 120 and a second power ELVSS.

That is, an anode electrode of the light emitting element LE may be electrically connected to the light emitting pixel driver EPD, and the second power ELVSS having a lower voltage level than the first power ELVDD may be applied to a cathode electrode of the light emitting element LE.

A capacitor Cel connected in parallel with the light emitting element LE represents a parasitic capacitance between the anode electrode and the cathode electrode.

The circuit layer 120 may include a first power line VDL that transmits the first power ELVDD, a gate initialization voltage line VGIL that transmits a gate initialization voltage VGINT, and an anode initialization voltage line VAIL that transmits an anode initialization voltage VAINT.

The circuit layer 120 may include gate lines GL electrically connected to a gate electrode of at least one of the transistors T1 to T7 provided in each light emitting pixel driver EPD.

The gate lines GL may include a scan write line GWL that transmits a scan write signal GW, a scan initialization line GIL that transmits a scan initialization signal GI, an emission control line ECL that transmits an emission control signal EC, and a gate control line GCL that transmits a gate control signal GC.

One light emitting pixel driver EPD of the circuit layer 120 may include a first transistor T1 that generates a driving current for driving the light emitting element LE, two or more transistors T2 to T7 electrically connected to the first transistor T1, and at least one pixel capacitor PC1.

The first transistor T1 may be disposed between a first node N1 and a second node N2. The first node N1 is electrically connected to a first electrode (e.g., a source electrode) of the first transistor T1. The second node N2 is electrically connected to a second electrode (e.g., a drain electrode) of the first transistor T1.

The first node N1 may be electrically connected between the first power line VDL through a fifth transistor T5.

The second node N2 may be electrically connected to the anode electrode of the light emitting element LE through a sixth transistor T6.

The pixel capacitor PC1 may be electrically connected between the first power line VDL and a third node N3. The third node N3 is electrically connected to a gate electrode of the first transistor T1.

That is, the gate electrode of the first transistor T1 may be electrically connected to the first power line VDL through the pixel capacitor PC1.

Accordingly, a potential of the gate electrode of the first transistor T1 may be maintained at a voltage charged in the pixel capacitor PC1.

The second transistor T2 may be electrically connected between the data line DL and the first node N1.

The second transistor T2 may be electrically connected between the first electrode of the first transistor T1 and the data line DL.

That is, the first electrode of the first transistor T1 may be electrically connected to the data line DL through the second transistor T2.

The second transistor T2 may be turned on by the scan write signal GW of the scan write line GWL.

The fifth transistor T5 may be electrically connected between the first node N1 and the first power line VDL.

The sixth transistor T6 may be electrically connected between the second node N2 and a fourth node N4. The fourth node N4 is electrically connected to the anode electrode of the light emitting element LE.

That is, the fifth transistor T5 may be electrically connected between the first electrode of the first transistor T1 and the first power line VDL.

The sixth transistor T6 may be electrically connected between the second electrode of the first transistor T1 and the anode electrode of the light emitting element LE.

The fifth transistor T5 and the sixth transistor T6 may be turned on by the emission control signal EC of the emission control line ECL.

When the data signal Vdata of the data line DL is transmitted to the first electrode of the first transistor T1 through the turned-on second transistor T2, a voltage difference between the gate electrode of the first transistor T1 and the first electrode of the first transistor T1 may be a difference voltage between the first power ELVDD and the data signal Vdata.

In this case, when the voltage difference between the gate electrode of the first transistor T1 and the first electrode of the first transistor T1, that is, a gate-source voltage difference is a threshold voltage or more, the first transistor T1 may be turned on, thereby generating a drain-source current of the first transistor T1 corresponding to the data signal Vdata.

Subsequently, when the fifth transistor T5 and the sixth transistor T6 are turned on, the first power ELVDD, the first transistor T1, the light emitting element LE, and the second power ELVSS may be connected in series with each other. Accordingly, the drain-source current of the first transistor T1 corresponding to the data signal Vdata may be supplied as a driving current of the light emitting element LE.

As a result, the light emitting element LE may emit light with luminance corresponding to the data signal Vdata.

The third transistor T3 may be disposed between the second node N2 and the third node N3. That is, the third transistor T3 may be electrically connected between the gate electrode of the first transistor T1 and the second electrode of the first transistor T1.

The third transistor T3 may include a plurality of sub-transistors connected in series with each other. As an example, the third transistor T3 may include a first sub-transistor T31 and a second sub-transistor T32.

A first electrode of the first sub-transistor T31 may be connected to the gate electrode of the first transistor T1, a second electrode of the first sub-transistor T31 may be connected to a first electrode of the second sub-transistor T32, and a second electrode of the second sub-transistor T32 may be connected to the second electrode of the first transistor T1.

In this way, the potential of the gate electrode of the first transistor T1 may be prevented from being changed due to a leakage current caused by a third transistor T3 that is not turned on.

The first sub-transistor T31 and the second sub-transistor T32 may be turned on by the scan write signal GW of the scan write line GWL.

When the first sub-transistor T31 and the second sub-transistor T32 are turned on, the voltage difference between the second node N2 and the third node N3 may be initialized.

The fourth transistor T4 may be electrically connected between the gate initialization voltage line VGIL and the third node N3. That is, the fourth transistor T4 may be connected between the gate electrode of the first transistor T1 and the gate initialization voltage line VGIL.

The fourth transistor T4 may include a plurality of sub-transistors connected in series with each other. As an example, the fourth transistor T4 may include a third sub-transistor T41 and a fourth sub-transistor T42.

A first electrode of the third sub-transistor T41 may be connected to the gate electrode of the first transistor T1, a second electrode of the third sub-transistor T41 may be connected to a first electrode of the fourth sub-transistor T42, and a second electrode of the fourth sub-transistor T42 may be connected to the gate initialization voltage line VGIL.

In this way, the potential of the gate electrode of the first transistor T1 may be prevented from being changed due to a leakage current caused by a fourth transistor T4 that is not turned on.

The third sub-transistor T41 and the fourth sub-transistor T42 may be turned on by the scan initialization signal GI of the scan initialization line GIL.

When the third sub-transistor T41 and the fourth sub-transistor T42 are turned on, the potential of the third node N3 may be initialized to the gate initialization voltage VGINT.

The seventh transistor T7 may be electrically connected between the fourth node N4 and the anode initialization voltage line VAIL. That is, the seventh transistor T7 may be electrically connected between the anode electrode of the light emitting element LE and the anode initialization voltage line VAIL.

The seventh transistor T7 may be turned on by the gate control signal GC of the gate control line GCL.

A potential of the fourth node N4 may be initialized to the anode initialization voltage VAINT through the turned-on seventh transistor T7.

As illustrated in FIG. 5, according to an embodiment, the first to seventh transistors T1 to T7 may be provided as P-type MOSFETs.

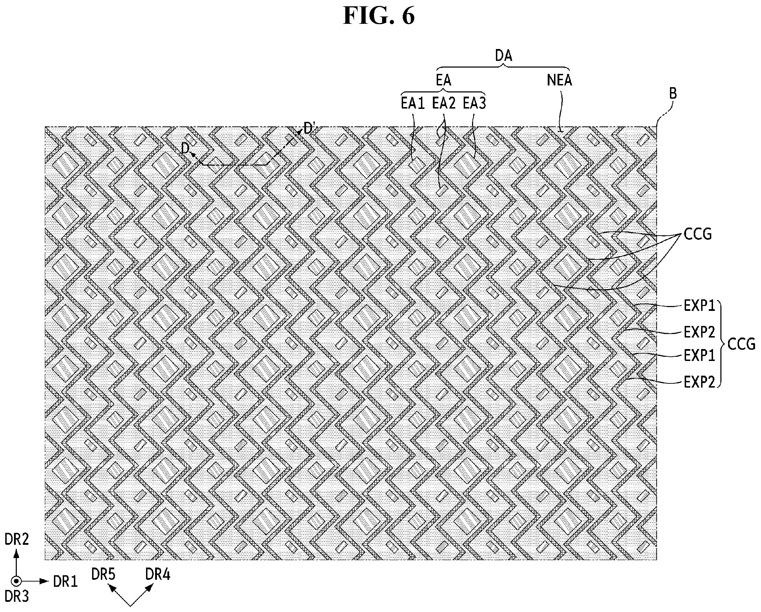

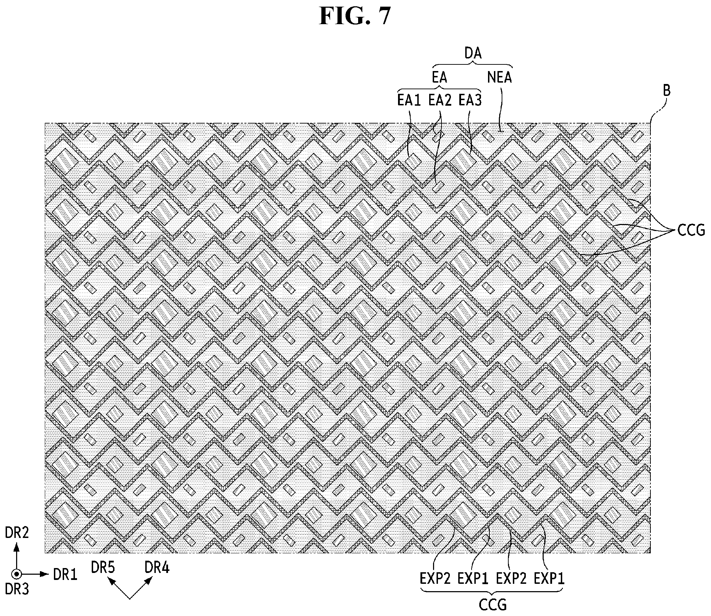

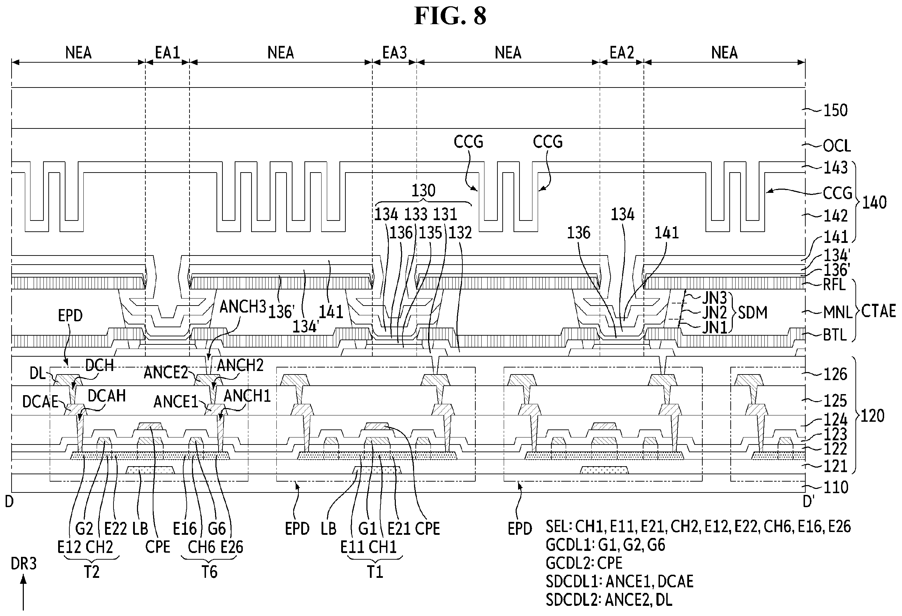

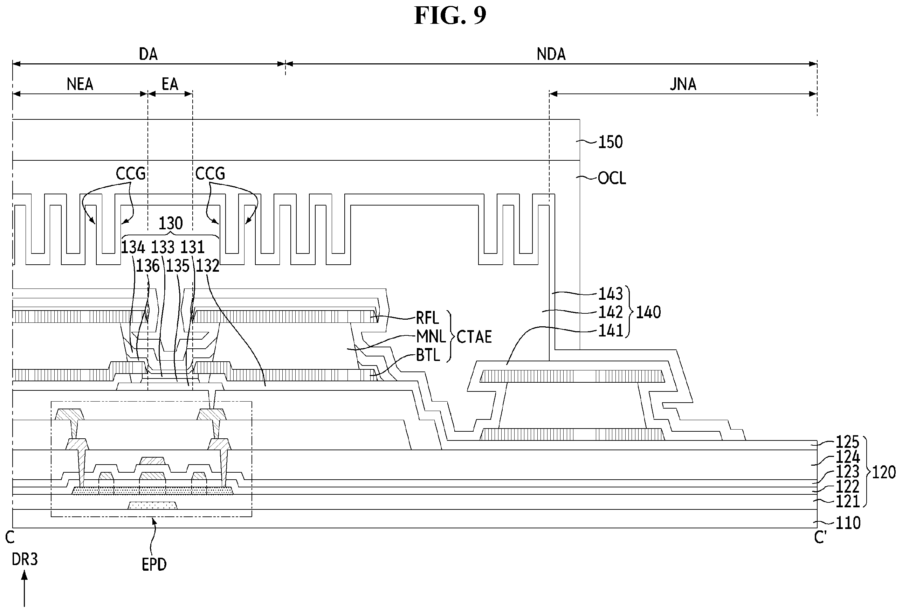

FIGS. 6 and 7 are layout views illustrating portion B of FIG. 2 according to embodiments. FIG. 8 is a cross-sectional view taken along line D-D' of FIG. 6. FIG. 9 is a cross-sectional view taken along line C-C' of FIG. 2 according to the embodiment of FIG. 6.

Referring to FIGS. 6 and 7, the display area DA of the display device 100 according to the embodiments may include light emitting areas EA arranged in the first direction DR1 or the second direction DR2, and a non-light emitting area NEA disposed between the light emitting areas EA.

The element layer (130 in FIG. 3) of the display device 100 according to the embodiments may include light emitting elements (LE in FIG. 5) disposed in the light emitting areas EA.

The sealing layer (140 in FIG. 3) of the display device 100 according to the embodiments may include concave grooves CCG disposed in the non-light emitting area NEA. The concave grooves may for example be termed zigzag grooves, serrated grooves, and/or spatially oscillating grooves.

As illustrated in FIGS. 6 and 7, each of the concave grooves CCG may extend in one of the first direction DR1 and the second direction DR2.

That is, according to an embodiment, as illustrated in FIG. 6, the concave grooves CCG may extend in the second direction DR2 and be spaced apart from each other in the first direction DR1.

In this case, each of the concave grooves CCG may include a bent shape in which first extension portions EXP1 extending in a first diagonal direction DR4 intersecting the first direction DR1 and the second direction DR2, and second extension portions EXP2 extending in a second diagonal direction DR5 intersecting the first direction DR1, the second direction DR2, and the first diagonal direction DR4 are alternately arranged in the second direction DR2.

Alternatively, as illustrated in FIG. 7, according to an embodiment, the concave grooves CCG may extend in the first direction DR1 and be spaced apart from each other in the second direction DR2.

In this case, each of the concave grooves CCG may include a bent shape in which the first extension portions EXP1 and the second extension portions EXP2 are alternately arranged in the first direction DR1.

According to embodiments, one or more light emitting areas EA may be disposed between the concave grooves CCG.

Alternatively, one column of light emitting areas EA or one row of light emitting areas EA may be disposed between the concave grooves CCG. Here, one column of light emitting areas EA may be arranged parallel to each other in the first direction DR1. In addition, one row of light emitting areas EA may be arranged parallel to each other in the second direction DR2.

Referring to FIG. 8, the display device 100 according to the embodiments may include a substrate 110, a circuit layer 120 on the substrate 110, an element layer 130 on the circuit layer 120, and a sealing layer 140 on the element layer 130.

The display device 100 according to the embodiments may further include a touch sensor layer 150 on the sealing layer 140, and a polarizing layer (160 in FIG. 3) on the touch sensor layer 150.

According to embodiments, the display device 100 may further include an overcoat layer OCL disposed between the sealing layer 140 and the touch sensor layer 150.

According to embodiments, the circuit layer 120 may include a substrate buffer layer 121 disposed on the substrate 110, a semiconductor layer SEL (CH1, E11, E21, CH6, E16, and E26) disposed on the substrate buffer layer 121, a first gate insulating layer 122 covering the semiconductor layer SEL, a first gate conductive layer GCDL1 (G1 and G6) disposed on the first gate insulating layer 122, a second gate insulating layer 123 covering the first gate conductive layer GCDL1, a second gate conductive layer GCDL2 (CPE) disposed on the second gate insulating layer 123, an interlayer insulating layer 124 covering the second gate conductive layer GCDL2, a first source-drain conductive layer SDCDL1 (ANCE1) disposed on the interlayer insulating layer 124, a first planarization layer 125 covering the first source-drain conductive layer SDCDL1, a second source-drain conductive layer SDCDL2 (ANCE2) disposed on the first planarization layer 125, and a second planarization layer 126 covering the second source-drain conductive layer SDCDL2.

The circuit layer 120 may include light emitting pixel drivers EPD each corresponding to the light emitting areas EA.

Each of the light emitting pixel drivers EPD may include a first transistor T1, and second to seventh transistors (T2 to T7 in FIG. 5) and at least one pixel capacitor (PC1 in FIG. 5) electrically connected to the first transistor T1.

A channel portion, a first electrode portion, and a second electrode portion of each of the P-type MOSFETs may be disposed on a semiconductor layer on the substrate buffer layer 121.

That is, channel portions CH1 and CH6, first electrode portions E11 and E16, and second electrode portions E21 and E26 of each of the first to seventh transistors T1 to T7 may be disposed on the semiconductor layer SEL on the substrate buffer layer 121.

In each of the first transistor T1 and the sixth transistor T6, the first electrode portions E11 and E16 may be connected to one end of the channel portions CH1 and CH6, and the second electrode portions E21 and E26 may be connected to other ends of the channel portions CH1 and CH6.

The second electrode portion E21 of the first transistor T1 may be connected to the first electrode portion E16 of the sixth transistor T6.

The gate electrode of each of the P-type MOSFETs may be disposed on the first gate conductive layer on the first gate insulating layer 122.

That is, the gate electrodes G1 and G6 of each of the first to seventh transistors T1 to T7 may be disposed on the first gate conductive layer on the first gate insulating layer 122.

In each of the first transistor T1 and the sixth transistor T6, the gate electrodes G1 and G6 may overlap the channel portions CH1 and CH6 in a plan view.

Since the second transistor T2, the first sub-transistor T31, the second sub-transistor T32, the third sub-transistor T41, the fourth sub-transistor T42, the fifth transistor T5, and the seventh transistor T7 of FIG. 5 are provided as P-type MOSFETs identical to the first transistor T1 and the sixth transistor T6, redundant description will be omitted below.

The capacitor electrode CPE may be disposed on the second gate conductive layer GCDL2 on the second gate insulating layer 123 and may overlap the gate electrode G1 of the first transistor T1 in a plan view.

The capacitor electrode CPE may be electrically connected to the first power line (VDL in FIG. 5).

Accordingly, a pixel capacitor (PC1 in FIG. 5) may be provided by an overlapping area between the capacitor electrode CPE and the gate electrode G1 of the first transistor T1.

The first source-drain conductive layer SDCDL1 on the interlayer insulating layer 124 may include a first anode connection electrode ANCE1.

The first anode connection electrode ANCE1 may be electrically connected to the second electrode portion E26 of the sixth transistor T6 through a first anode connection hole ANCH1.

The second source-drain conductive layer SDCDL2 on the first planarization layer 125 may include a second anode connection electrode ANCE2.

The second anode connection electrode ANCE2 may be electrically connected to the first anode connection electrode ANCE1 through a second anode connection hole ANCH2.

The anode electrode 131 of the element layer 130 may be disposed on the second planarization layer 126, and may be electrically connected to the second anode connection electrode ANCE2 through a third anode connection hole ANCH3.

As a result, the anode electrode 131 may be electrically connected to the second electrode portion E26 of the sixth transistor T6 through the first anode connection electrode ANCE1 and the second anode connection electrode ANCE2.

The element layer 130 on the circuit layer 120 may include light emitting elements LE disposed in the light emitting areas EA1, EA2, and EA3, respectively.

Each of the light emitting elements LE may include a structure in which the light emitting layer 133 is disposed between the anode electrode 131 and the cathode electrode 134 that face each other.

Each of the light emitting elements LE may further include a first common layer 135 disposed between the anode electrode 131 and the light emitting layer 133, and a second common layer 136 disposed between the light emitting layer 133 and the cathode electrode 134.

The first common layer 135 may include an organic material having hole transport properties or hole injection properties.

The second common layer 136 may include an organic material having electron transport properties or electron injection properties.

As a result, according to embodiments, the element layer 130 may include anode electrodes 131 each disposed in the light emitting areas EA, a pixel defining layer 132 disposed in the non-light emitting area NEA and covering edges of the anode electrodes 131, a cathode auxiliary electrode CTAE disposed on the pixel defining layer 132, first common layers 135 disposed on the anode electrodes 131, light emitting layers 133 disposed on the first common layers 135, second common layers 136 disposed on the light emitting layers 133, and cathode electrodes 134 disposed on the second common layers 136.

In order to dispose the cathode auxiliary electrode CTAE on the pixel defining layer 132, the pixel defining layer 132 may include an inorganic insulating material.

Edges of the cathode electrodes 134 may be in contact with the cathode auxiliary electrode CTAE. As a result, the cathode electrodes 134 may be electrically connected to each other through the cathode auxiliary electrode CTAE.

The cathode auxiliary electrode CTAE may include a main layer MNL including a metal material of relatively low resistance, and a roof layer RFL disposed on the main layer MNL and including a metal material different from the metal material of the main layer MNL. An undercut portion may be defined by a bottom surface of the roof layer and a side surface of the man layer, overlap the cathode electrodes 134 in a plan view and have a shape in which an edge of the roof layer RFL more protrudes than the main layer MNL.

Since the roof layer RFL and the main layer MNL include different metal materials, the roof layer RFL and the main layer MNL may have different etching rates. Due to a difference in etching rate, a side surface of the main layer MNL may not be parallel to the edge of the roof layer RFL and may be disposed more concavely than the edge of the roof layer RFL. As a result, the cathode auxiliary electrode CTAE may include the undercut portion.

The cathode auxiliary electrode CTAE may further include a bottom layer BTL disposed below the main layer MNL and including a metal material different from the metal material of the main layer MNL.

The bottom layer BTL may include the same metal material as the roof layer RFL.

As an example, the main layer MNL may include low-resistance metal materials such as aluminum (Al) and copper (Cu), and each of the roof layer RFL and the bottom layer BTL may include titanium (Ti).

The anode electrodes 131 may be prepared through a process of using an etching blocking mask.

The first common layers 135 and the light emitting layers 133 may be prepared by a process of using a micro mask including openings each facing at least some of the light emitting areas EA.

On the other hand, for an easier process, the second common layers 136 and the cathode electrodes 134 may be prepared by a process of using a mask including an opening facing the display area DA.

As a result, the edges of the second common layers 136 and the edges of the cathode electrodes 134 may be in contact with a side surface SDM of the main layer MNL of the cathode auxiliary electrode CTAE.

In addition, the material of the second common layers 136 and the material of the cathode electrodes 134 may also be disposed in the non-light emitting area NEA.

Accordingly, the element layer 130 may further include a dummy common portion 136' including the same material as the second common layers 136 on the cathode auxiliary electrode CTAE, and a dummy cathode portion 134' covering the dummy common portion 136' and including the same material as the cathode electrodes 134.

The dummy common portion 136' may be spaced apart from the second common layers 136 by the undercut portion of the cathode auxiliary electrode CTAE.

The dummy cathode portion 134' may be spaced apart from the cathode electrodes 134 by the undercut portion of the cathode auxiliary electrode CTAE.

According to embodiments, the sealing layer 140 may include a first sealing layer 141 disposed on the element layer 130 and including an inorganic insulating material, a second sealing layer 142 disposed on the first sealing layer 141 and including an organic insulating material, concave grooves CCG formed in the non-light emitting area NEA and recessed through at least a portion of the second sealing layer 142, and a third sealing layer 143 covering the second sealing layer 142 and the concave grooves CCG and including an inorganic insulating material.

The first sealing layer 141 covers the cathode electrodes 134 and the dummy cathode portion 134'.

Since the cathode electrodes 134 are separated from the dummy cathode portion 134' by the undercut portion of the cathode auxiliary electrode CTAE, the first sealing layer 141 may be in contact with the cathode auxiliary electrode CTAE.

That is, the first sealing layer 141 may be in contact with a side surface of the main layer MNL of the cathode auxiliary electrode CTAE and may be connected to an upper surface of the roof layer RFL while filling the undercut portion.

Accordingly, the side surface SDM of the main layer MNL of the cathode auxiliary electrode CTAE may include a first junction portion JN1 in contact with the edges of the second common layers 136, a second junction portion JN2 in contact with the edges of the cathode electrodes 134, and a third junction portion JN3 in contact with the first sealing layer 141.

In this way, the light emitting elements LE of the light emitting areas EA may be individually sealed by the junction structure between the first sealing layer 141 and the main layer MNL. This may further delay deterioration of the light emitting elements LE due to permeation of oxygen or moisture.

Considering the arrangement of the concave grooves CCG, the second sealing layer 142 may include an organic insulating material that is relatively easy to selectively remove.

As an example, the second sealing layer 142 may include a photoresist material.

The third sealing layer 143 may be prepared through a process of using the atomic layer deposition (ALD) method. In this way, the third sealing layer 143 may be relatively evenly disposed not only on flat portions such as the bottom surfaces of the concave grooves CCG and the gaps between the concave grooves CCG, but also on the side surfaces of the concave grooves CCG.

Therefore, even if the sealing layer 140 further includes the concave grooves CCG, the capping of the second sealing layer 142 by the first sealing layer 141 and the third sealing layer 143 may be relatively and stably implemented.

The display device 100 according to the embodiments may further include an overcoat layer OCL disposed between the sealing layer 140 and the touch sensor layer 150.

The overcoat layer OCL may be disposed on the third sealing layer 143 of the sealing layer 140 and may include an organic insulating material.

As an example, the overcoat layer OCL may include an organic insulating material having a relatively low coefficient of expansion and a relatively low permittivity and being formable in a low temperature environment.

Accordingly, since the concave grooves CCG may be filled and supported by the overcoat layer OCL on the third sealing layer 143, cracks or damage to the third sealing layer 143 due to the concave grooves CCG may be prevented.

In addition, as the touch sensor layer 150 is disposed on one flat surface of the overcoat layer OCL, defects in the touch sensor layer 150 may be reduced.

Referring to FIG. 9, the non-display area NDA of the display device 100 according to the embodiments may include a junction area JNA surrounding the display area DA.

The second sealing layer 142 may be disposed in an area surrounded by the junction area JNA.

Accordingly, the third sealing layer 143 covering the second sealing layer 142 may be in contact with the first sealing layer 141 under the second sealing layer 142 in the junction area JNA.

In addition, according to embodiments, the organic insulating material included in the first planarization layer 125 and the second planarization layer 126 of the circuit layer 120 may be spaced from the junction area JNA.

Accordingly, the first sealing layer 141 may be in contact with the inorganic insulating material of the circuit layer 120 or the inorganic insulating material of the element layer 130 in the junction area JNA.

As an example, when the pixel defining layer 132 of the element layer 130 extends to the junction area JNA, the first sealing layer 141 may be in contact with the pixel defining layer 132 in the junction area JNA.

Alternatively, when the pixel defining layer 132 of the element layer 130 is spaced apart from the junction area JNA, the first sealing layer 141 may be in contact with the interlayer insulating layer 124 of the circuit layer 120 in the junction area JNA.

As a result, since a junction structure of inorganic material may be provided in the junction area JNA, permeation of oxygen or moisture into the organic materials of the element layer 130 and the circuit layer 120 may be delayed.

Therefore, the lifespan of the display device 100 may be improved.

According to the embodiments as described above, the sealing layer 140 includes the concave grooves CCG recessed through at least a portion of the second sealing layer 142. The third sealing layer 143 covers the concave grooves CCG together with the second sealing layer 142, and thus may have a wider surface area than the second sealing layer 142. In addition, since the gap between the concave grooves CCG has a smaller width than the light emitting areas EA, flexibility of the third sealing layer 143 may be increased.

Therefore, since cracks and damage to the third sealing layer 143 due to shape deformation or external shock may be reduced, the lifespan and display quality of the display device 100 may be improved.

According to embodiments, some of the concave grooves CCG may be disposed in the non-display area NDA. In this way, since the flexibility of the non-display area NDA is also improved, so that the stress caused by shape deformation or external shock to the non-display area NDA may be alleviated, the lifespan and display quality of the display device 100 may be improved.

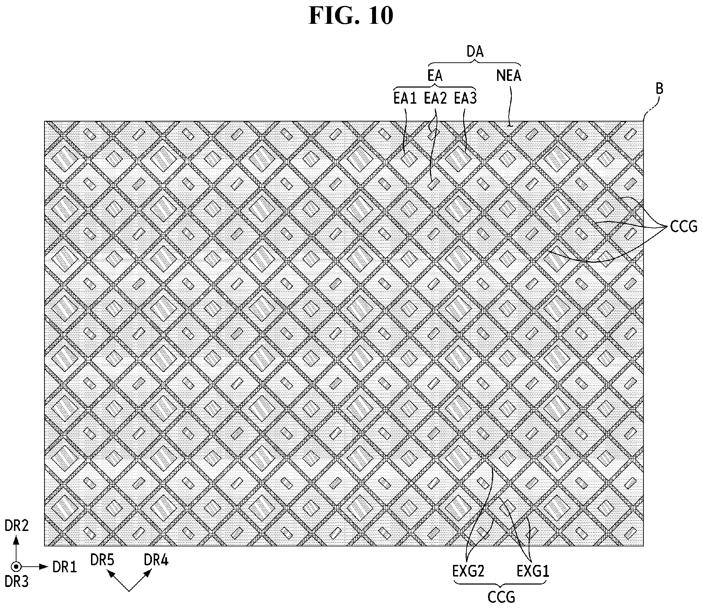

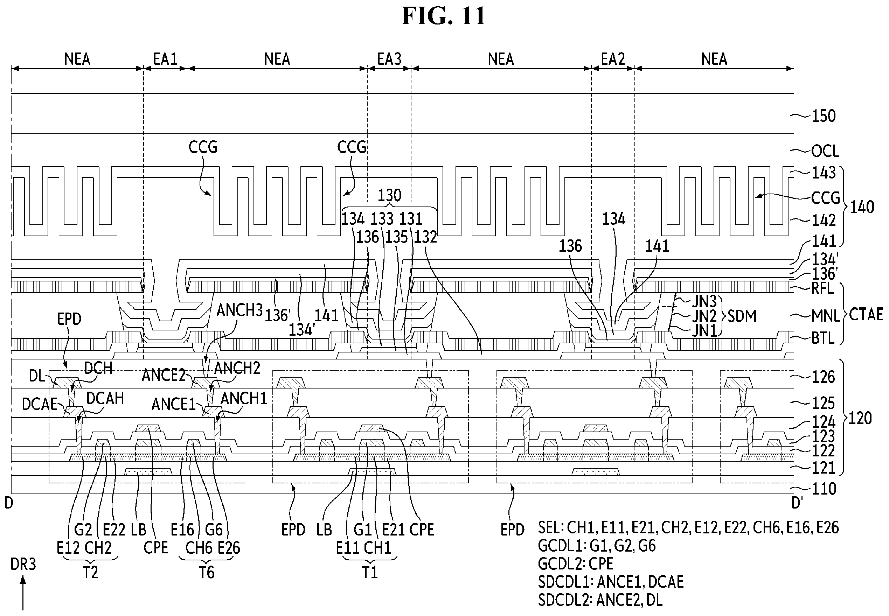

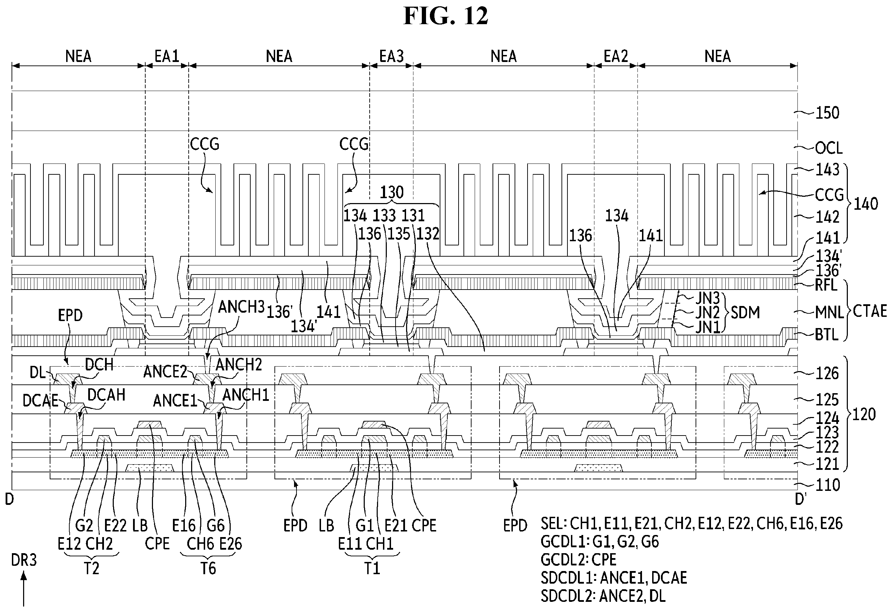

FIG. 10 is a layout view illustrating portion B of FIG. 2 according to an embodiment. FIGS. 11 and 12 are cross-sectional views taken along line D-D' of FIG. 6 according to embodiments.

Since the display device 100 according to an embodiment illustrated in FIGS. 10 and 11 is substantially the same as the embodiments illustrated in FIGS. 6 to 9, except that the concave grooves CCG do not extend in the first direction DR1 or the second direction DR2, but include first extension grooves EXG1 and second extension grooves EXG2 that intersect each other, redundant description will be omitted below.

Each of the first extension grooves EXG1 may extend in the first diagonal direction DR4.

Each of the second extension grooves EXG2 may extend in the second diagonal direction DR5.

In this way, since the concave grooves CCG may be regularly arranged, visibility may be reduced and an optical characteristic variation rate due to the concave grooves CCG may be reduced.

According to embodiments, since the dummy cathode portion 134' and the concave grooves CCG on the pixel defining layer 132 are all disposed in the non-light emitting area NEA, the concave grooves CCG may overlap the dummy cathode portion 134' in a plan view.

According to an embodiment, as illustrated in FIGS. 7, 8, and 11, the concave grooves CCG may be defined in a portion of the second sealing layer 142. In this case, since another portion of the second sealing layer 142 remains between the concave grooves CCG and the first sealing layer 141, the concave grooves CCG may be spaced apart from the first sealing layer 141.

In this way, since foreign matter in the non-light emitting area NEA may be covered by another portion of the second sealing layer 142, image quality defects caused by foreign matter may be reduced.

According to another embodiment, as illustrated in FIG. 12, the concave grooves CCG may penetrate through the second sealing layer 142.

In this case, the third sealing layer 143 may be in contact with the first sealing layer 141 through the concave grooves CCG.

In this way, since the inorganic junction between the first sealing layer 141 and the third sealing layer 143 may be disposed in the non-light emitting area NEA by the concave grooves CCG, the individual sealing of the light emitting elements LE may be made more robust. As a result, since the deterioration period of the light emitting elements LE may be further delayed, the lifespan and display quality of the display device 100 may be improved.

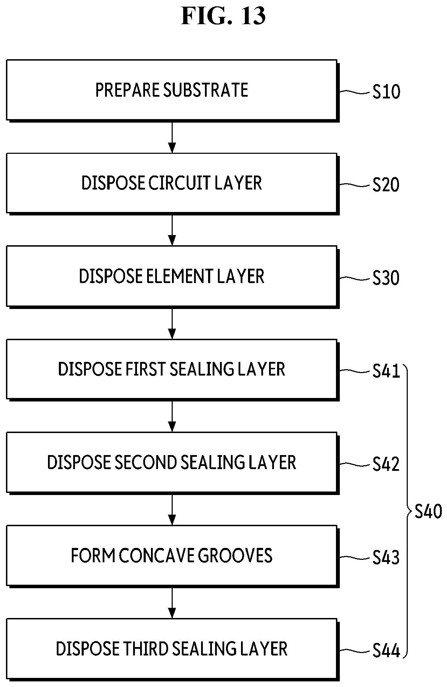

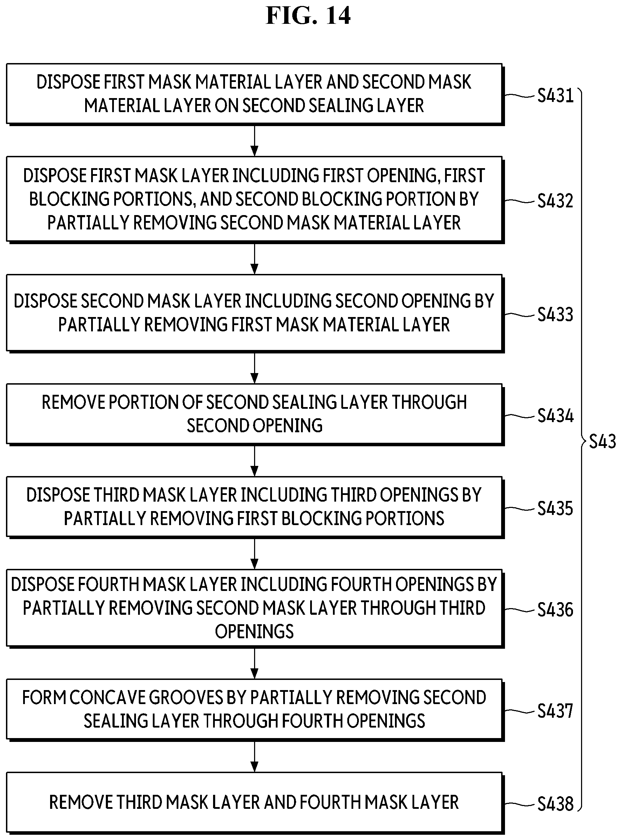

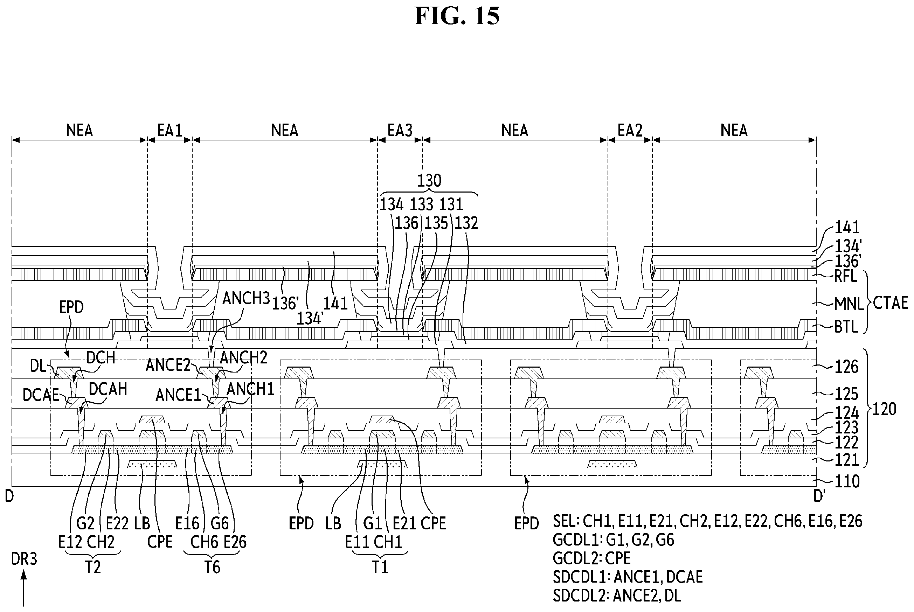

FIG. 13 is a flowchart illustrating a method for manufacturing a display device according to embodiments. FIG. 14 is a flowchart illustrating a step of forming concave grooves of FIG. 13. FIGS. 15, 16, 17, 18, 19, 20, 21, 22, 23, 24 and 25 are process views illustrating some steps of the flowcharts of FIGS. 13 and 14.

Referring to FIG. 13, a method for manufacturing a display device 100 according to embodiments may include a step (S10) of preparing a substrate 110, a step (S20) of disposing a circuit layer 120 on the substrate 110, a step (S30) of disposing an element layer 130 on the circuit layer 120, and a step (S40) of disposing a sealing layer 140 on the element layer 130.

In the step (S10) of disposing the substrate 110, the substrate 110 may include a display area DA in which light emitting areas EA are arranged, and a non-display area NDA disposed around the display area DA.

The non-display area NDA may include a junction area JNA surrounding the display area DA.

The step (S40) of disposing the sealing layer 140 may include a step (S41) of disposing a first sealing layer 141 including an inorganic insulating material on the element layer 130, a step (S42) of disposing a second sealing layer 142 including an organic insulating material on the first sealing layer 141, a step (S43) of forming concave grooves CCG recessed through at least a portion of the second sealing layer 142 in the non-light emitting area NEA between the light emitting areas EA, and a step (S44) of disposing a third sealing layer 143 covering the second sealing layer 142 and the concave grooves CCG and including an inorganic insulating material.

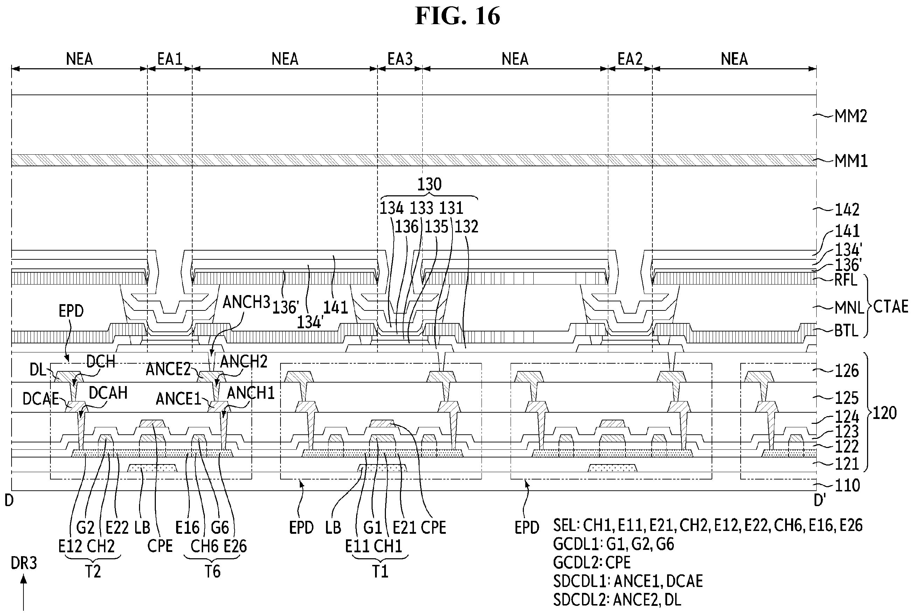

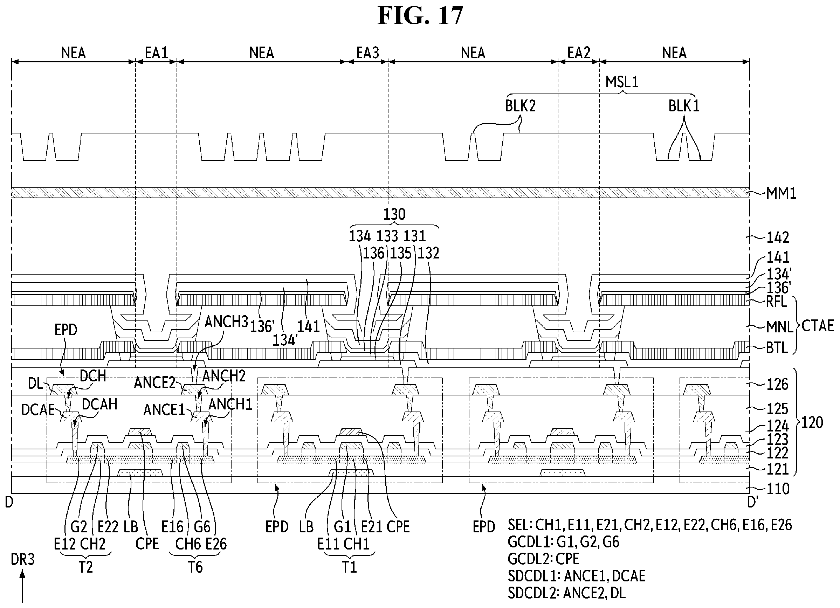

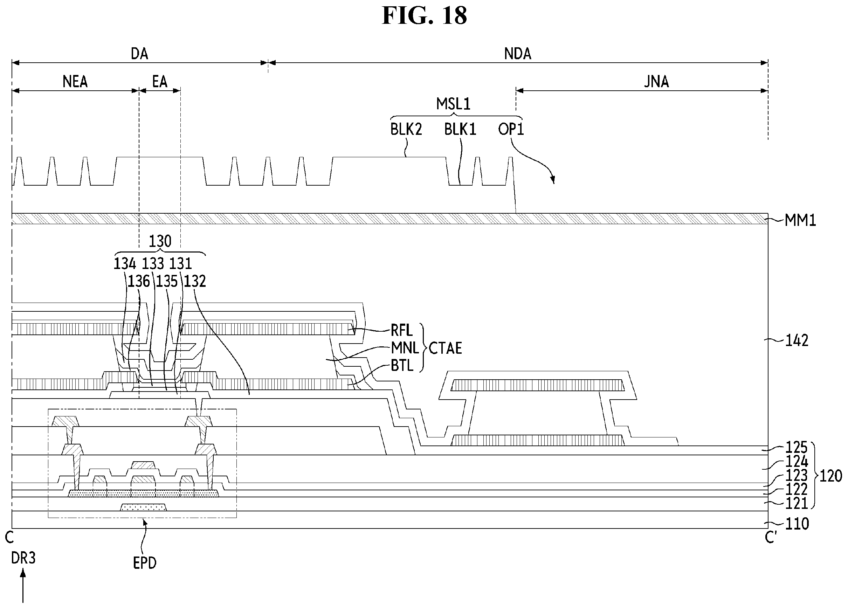

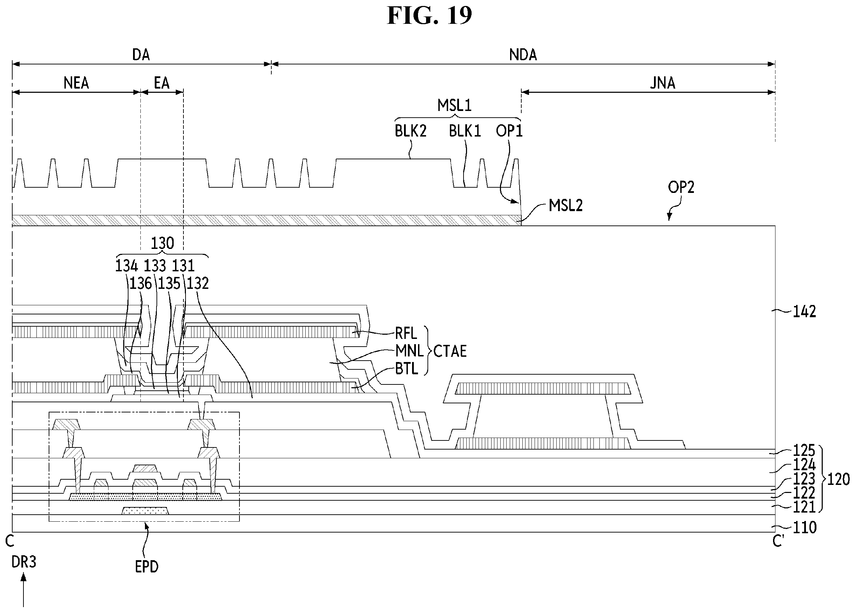

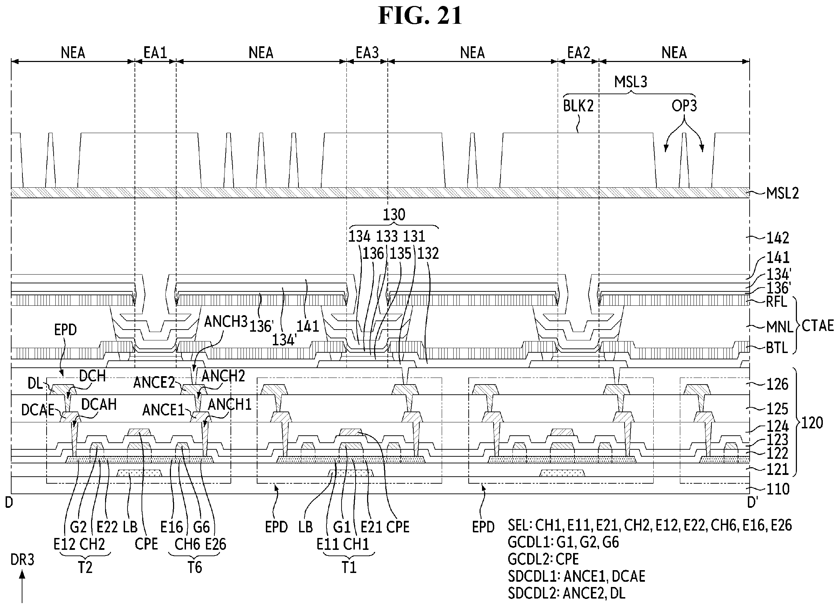

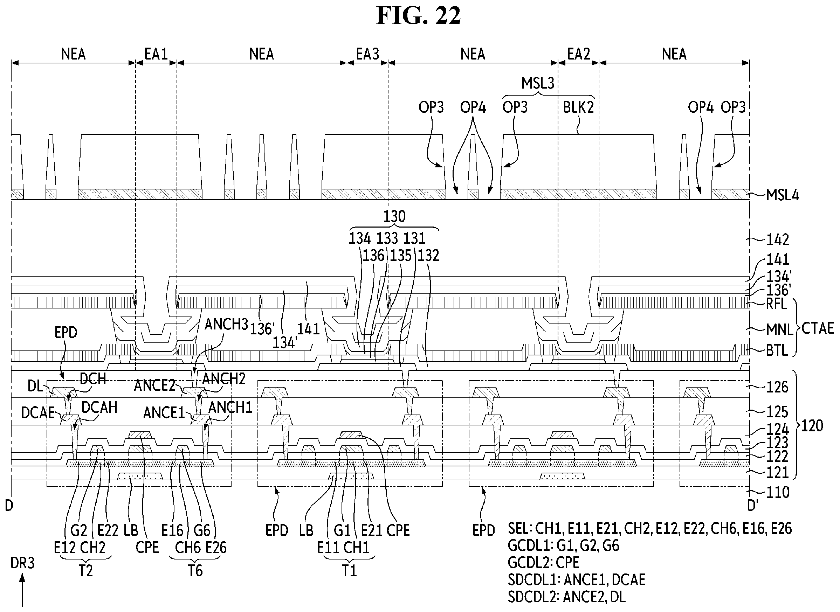

Referring to FIG. 14, the step (S43) of forming the concave grooves CCG may include a step (S431) of sequentially disposing a first mask material layer (MM1 in FIG. 16) including a metal material and a second mask material layer (MM2 in FIG. 16) including a photoresist material on the second sealing layer 142; a step (S432) of forming a first mask layer (MSL1 in FIGS. 17 and 18) including a first opening (OP1 in FIG. 18) facing the junction area JNA, first blocking portions (BLK1 in FIGS. 17 and 18) arranged in the non-light emitting area NEA, and a second blocking portion (BLK2 in FIGS. 17 and 18) that is thicker than the first blocking portions BLK1 in the non-light emitting area, by partially removing the second mask material layer MM2; a step (S433) of forming a second mask layer (MSL2 in FIG. 19) including a second opening (OP2 in FIG. 19) by removing a portion of the first mask material layer MM1 exposed by the first opening OP1; a step (S434) of removing a portion of the second sealing layer 142 exposed by the second opening OP2; a step (S435) of forming a third mask layer (MSL3 in FIG. 21) including third openings (OP3 in FIG. 21) by removing the first blocking portions BLK1 of the first mask layer MSL1; a step (S436) of forming a fourth mask layer MSL4 including fourth openings (OP4 in FIG. 22) by removing a portion of the second mask layer MSL2 exposed by the third openings OP3; a step (S437) of forming concave grooves CCG by partially removing the second sealing layer 142 exposed by the fourth openings OP4; and a step (S438) of removing the third mask layer MSL3 and the fourth mask layer MSL4. Here, thickness is measured in the thickness direction (i.e., third direction DR3).

Referring to FIG. 15, in the step (S41) of disposing the first sealing layer 141, the first sealing layer 141 may be disposing by stacking an inorganic insulating material on the element layer 130.

The element layer 130 may include anode electrodes 131 each disposed in the light emitting areas EA, a pixel defining layer 132 disposed in the non-light emitting area NEA and covering edges of the anode electrodes 131, a cathode auxiliary electrode CTAE disposed on the pixel defining layer 132, first common layers 135 disposed on the anode electrodes 131, light emitting layers 133 disposed on the first common layers 135, second common layers 136 disposed on the light emitting layers 133, and cathode electrodes 134 disposed on the second common layers 136.

The cathode auxiliary electrode CTAE may include a main layer MNL including a metal material of relatively low resistance, and a roof layer RFL disposed on the main layer MNL and including a metal material different from the main layer MNL. An undercut portion may be defined by a bottom surface of the roof layer RFL and a side surface of the man layer MNL, overlap the cathode electrodes 134 in a plan view and have a shape in which an edge of the roof layer RFL more protrudes than the main layer MNL.

The element layer 130 may further include a dummy common portion 136' including the same material as the second common layers 136 on the cathode auxiliary electrode CTAE, and a dummy cathode portion 134' covering the dummy common portion 136' and including the same material as the cathode electrodes 134.

As the cathode auxiliary electrode CTAE includes the undercut portion, the side surface SDM of the main layer MNL of the cathode auxiliary electrode CTAE may be in contact with the edges of the second common layers 136 and the edges of the cathode electrodes 134.

Since the cathode electrodes 134 are separated from the dummy cathode portion 134' by the undercut portion of the cathode auxiliary electrode CTAE, the first sealing layer 141 may be in contact with the side surface SDM of the main layer MNL of the cathode auxiliary electrode CTAE in the step (S41) of disposing the first sealing layer 141.

That is, the side surface SDM of the main layer MNL of the cathode auxiliary electrode CTAE may include a first junction portion JN1 in contact with the edges of the second common layers 136, a second junction portion JN2 in contact with the edges of the cathode electrodes 134, and a third junction portion JN3 in contact with the first sealing layer 141.

Referring to FIGS. 16 and 18, in the step (S42) of disposing the second sealing layer 142, the second sealing layer 142 may be disposed by entirely applying an organic insulating material over the first sealing layer 141.

Next, referring to FIG. 16, in the step (S431) of disposing the first mask material layer MM1 and the second mask material layer MM2, the first mask material layer MM1 may be disposed by stacking a metal material on the second sealing layer 142, and the second mask material layer MM2 may be disposed by stacking a photosensitive material on the first mask material layer MM1.

Referring to FIGS. 17 and 18, in the step (S432) of forming the first mask layer MSL1, the first mask layer MSL1 including a first opening OP1, first blocking portions BLK1, and a second blocking portion BLK2 may be performed by partially exposing the second mask material layer MM2 differently using a halftone mask.

The first opening OP1 may overlap the junction area JNA.

The first blocking portions BLK1 may be arranged in the non-light emitting area NEA.

Some of the first blocking portions BLK1 may be disposed in the non-display area NDA and spaced apart from the junction area JNA.

The second blocking portion BLK2 may be formed of a portion of the second mask material layer MM2 that remains unetched.

Referring to FIG. 19, in the step (S433) of forming the second mask layer MSL2, the second mask layer MSL2 including the second opening OP2 may be disposed by removing a portion of the first mask material layer MM1 exposed through the first opening OP1 of the first mask layer MSL1,

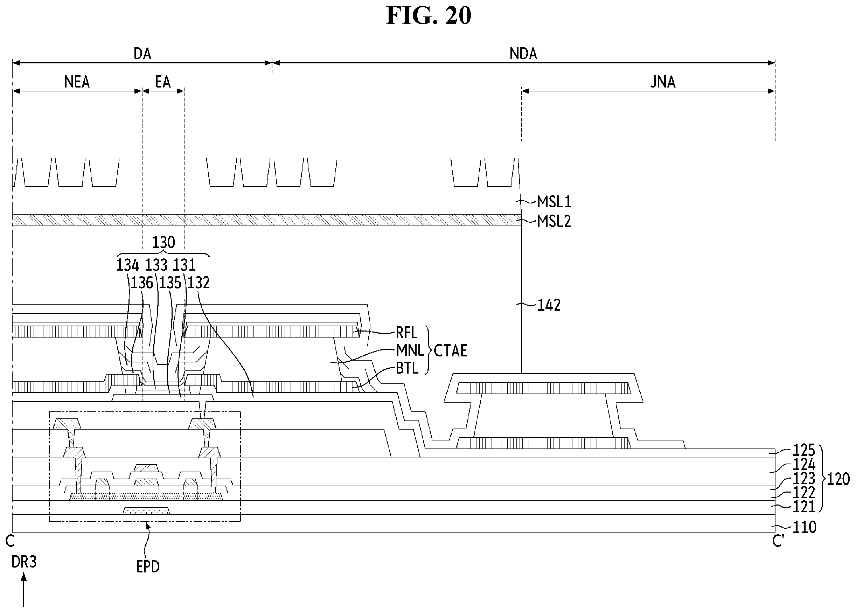

Referring to FIG. 20, in the step (S434) of removing a portion of the second sealing layer 142, a portion of the second sealing layer 142 exposed through the first opening OP1 and the second opening OP2 may be removed.

Accordingly, a portion of the first sealing layer 141 disposed in the junction area JNA may be exposed.

Referring to FIG. 21, in the step (S435) of forming of the third mask layer MSL3, the third mask layer MSL3 including third openings OP3 may be done by performing ashing on the first mask layer MSL1 to remove the first blocking portions BLK1 of the first mask layer MSL1.

The third openings OP3 are a variation of the first blocking portion BLK1 and may therefore be arranged in the non-light emitting area NEA.

Referring to FIG. 22, in the step (S436) of forming the fourth mask layer MSL4, the fourth mask layer MSL4 including fourth openings OP4 may be performed by removing portions of the second mask layer MSL2 exposed through the third openings OP3.

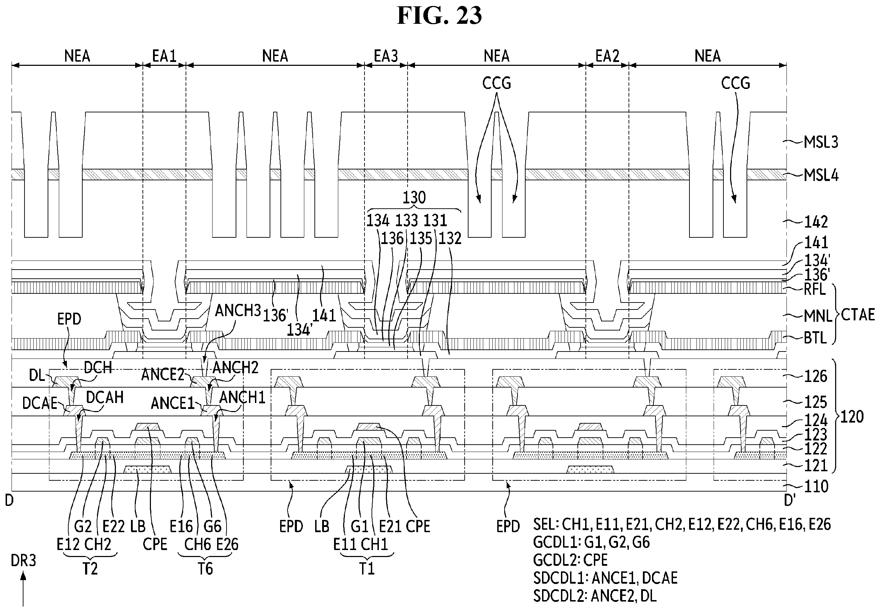

Referring to FIG. 23, in the step (S437) forming the concave grooves, the concave grooves CCG recessed through at least a portion of the second sealing layer 142 may be performed by partially removing the second sealing layer 142 exposed through the third openings OP3 and the fourth openings OP4.

According to an embodiment, by adjusting an etching intensity of the second sealing layer 142, each of the concave grooves CCG may be recessed through only a portion of the second sealing layer 142.

According to another embodiment, each of the concave grooves CCG may penetrate through the second sealing layer 142. In this case, the first sealing layer 141 may be exposed through the concave grooves CCG.

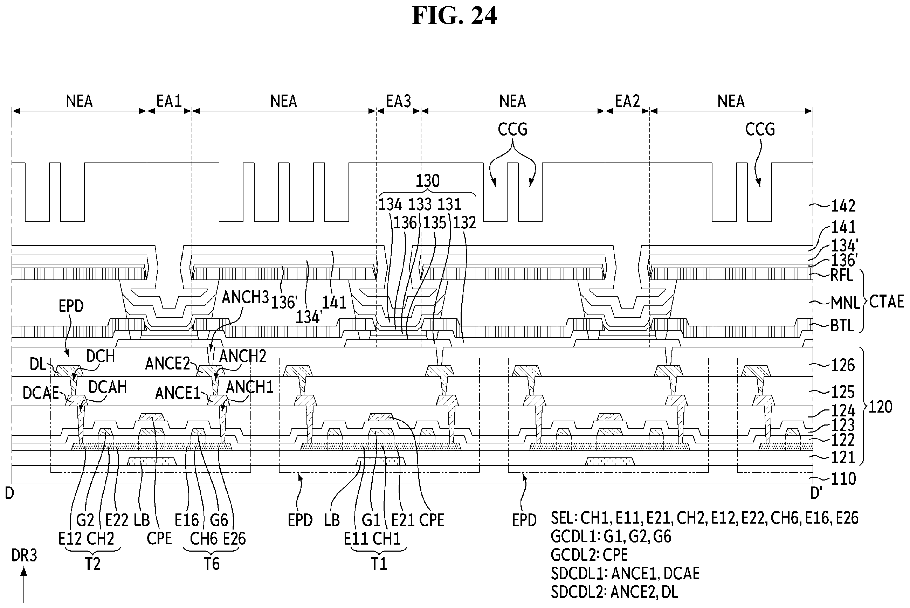

Referring to FIG. 24, after the step (S438) of removing the third mask layer MSL3 and the fourth mask layer MSL4, the second sealing layer 142 may be exposed between the concave grooves CCG.

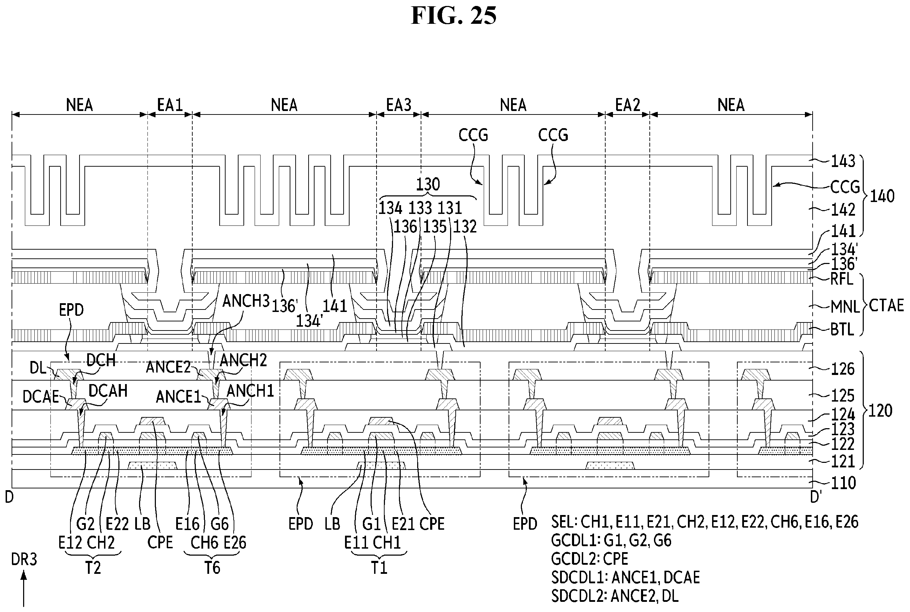

Referring to FIG. 25, in the step (S44) of disposing the third sealing layer 143, the third sealing layer 143 may be disposing by stacking an inorganic insulating material covering the second sealing layer 142 and the concave grooves CCG.

The third sealing layer 143 may be in contact with the first sealing layer 141 exposed at the junction area JNA.

However, the effects of the present disclosure are not restricted to the one set forth herein. The above and other effects of the present disclosure will become more apparent to one of daily skill in the art to which the present disclosure pertains by referencing the claims.

Embodiments are set out in the following clauses:
1. A display device comprising:
   a substrate including a display area in which light emitting areas are arranged;
   a circuit layer disposed on the substrate;
   an element layer disposed on the circuit layer; and
   a sealing layer disposed on the element layer,
   wherein the sealing layer includes:
      a first sealing layer disposed on the element layer and including an inorganic insulating material;
      a second sealing layer disposed on the first sealing layer and including an organic insulating material;
      concave grooves defined in a non-light emitting area between the light emitting areas and recessed through at least a portion of the second sealing layer; and
      a third sealing layer covering the second sealing layer and the concave grooves and including an inorganic insulating material.
2. The display device of clause 1, wherein the element layer includes:
   anode electrodes disposed in the light emitting areas;
   a pixel defining layer disposed in the non-light emitting area and covering edges of the anode electrodes;
   a cathode auxiliary electrode disposed on the pixel defining layer;
   first common layers disposed on the anode electrodes;
   light emitting layers disposed on the first common layers;
   second common layers disposed on the light emitting layers; and
   cathode electrodes disposed on the second common layers,
   wherein the pixel defining layer includes an inorganic insulating material, and
   edges of the cathode electrodes are in contact with the cathode auxiliary electrode.
3. The display device of clause 2, wherein the cathode auxiliary electrode includes:
   a main layer; and
   a roof layer disposed on the main layer and including a metal material different from a material of the main layer,
   wherein an undercut portion is defined by a bottom surface of the roof layer and a side surface of the man layer, overlaps a corresponding cathode electrode among the cathode electrodes and has a shape in which an edge of the roof layer more protrudes than the main layer.
4. The display device of clause 3, wherein the element layer further includes:
   a dummy common portion disposed on the pixel defining layer, including a same material as the second common layers, and spaced apart from the second common layers by the undercut portion; and
   a dummy cathode portion covering the dummy common portion, including a same material as the cathode electrodes, and spaced apart from the cathode electrodes by the undercut portion, and
   wherein the first sealing layer covers the cathode electrodes and the dummy cathode portion and is in contact with the cathode auxiliary electrode,
   wherein the side surface of the main layer includes:
      a first junction portion in contact with a corresponding edge of the second common layers;
      a second junction portion in contact with a corresponding edge of the edges of the cathode electrodes; and
      a third junction portion in contact with the first sealing layer.
5. The display device of clause 4, wherein the concave grooves overlap the dummy cathode portion, and
   at least some of the concave grooves are spaced apart from the first sealing layer.
6. The display device of any of clauses 4 to 5, wherein the concave grooves overlap the dummy cathode portion, and
   at least some of the concave grooves penetrate the second sealing layer,
   wherein the third sealing layer is in contact with the first sealing layer through the concave grooves.
7. The display device of any of clauses 2 to 6, wherein each of the concave grooves extends in one of a first direction and a second direction in which the light emitting areas are arranged.
8. The display device of clause 7, wherein each of the concave grooves includes a bent shape in which first extension portions extending in a first diagonal direction intersecting the first direction and the second direction, and second extension portions extending in a second diagonal direction intersecting the first direction, the second direction, and the first diagonal direction are alternately arranged in the first direction or the second direction.
9. The display device of any of clauses 2 to 8, wherein the concave grooves include first extension grooves and second extension grooves, which intersect each other.
10. The display device of any of clauses 2 to 9, further comprising an overcoat layer disposed on the third sealing layer, including an organic insulating material, and filling the concave grooves.
11. An electronic device comprising:
   a display device providing a screen,
   wherein the display device includes:
      a substrate including a display area in which light emitting areas are arranged, and a non-display area disposed around the display area;
      a circuit layer disposed on the substrate;
      an element layer disposed on the circuit layer; and
      a sealing layer disposed on the element layer,
      wherein the sealing layer includes:
         a first sealing layer disposed on the element layer and including an inorganic insulating material;
         a second sealing layer disposed on the first sealing layer and including an organic insulating material;
         concave grooves defined in a non-light emitting area between the light emitting areas and recessed through at least a portion of the second sealing layer; and
         a third sealing layer covering the second sealing layer and the concave grooves and including an inorganic insulating material,
         wherein the non-display area includes a junction area surrounding the display area,
         the second sealing layer is disposed in an area surrounded by the junction area, and
         in the junction area, the third sealing layer is in contact with the first sealing layer.
12. The electronic device of clause 11, wherein each of the concave grooves extends in one of a first direction and a second direction in which the light emitting areas are arranged,
   wherein each of the concave grooves includes a bent shape in which first extension portions extending in a first diagonal direction intersecting the first direction and the second direction, and second extension portions extending in a second diagonal direction intersecting the first direction, the second direction, and the first diagonal direction are alternately arranged in the first direction or the second direction.
13. The electronic device of clause 11 or clause 12, wherein the concave grooves include first extension grooves and second extension grooves, which intersect each other.
14. The electronic device of any of clauses 11 to 13, wherein the element layer further includes:
   anode electrodes disposed in the light emitting areas;
   a pixel defining layer disposed in the non-light emitting area and covering edges of the anode electrodes;
   a cathode auxiliary electrode disposed on the pixel defining layer;
   first common layers disposed on the anode electrodes;
   light emitting layers disposed on the first common layers;
   second common layers disposed on the light emitting layers; and
   cathode electrodes disposed on the second common layers,
   wherein the pixel defining layer includes an inorganic insulating material,
   edges of the cathode electrodes are in contact with the cathode auxiliary electrode, and
   the cathode auxiliary electrode includes:
      a main layer; and
      a roof layer disposed on the main layer and including a metal material different from a material of the main layer,
      wherein an undercut portion is defined by a bottom surface of the roof layer and a side surface of the man layer, overlaps a corresponding cathode electrode among the cathode electrodes and has a shape in which an edge of the roof layer more protrudes than the main layer,
      wherein the element layer further includes:
         a dummy common portion disposed on the pixel defining layer, including a same material as the second common layers, and spaced apart from the second common layers by the undercut portion; and
         a dummy cathode portion covering the dummy common portion, including a same material as the cathode electrodes, and spaced apart from the cathode electrodes by the undercut portion,
         wherein the first sealing layer covers the cathode electrodes and the dummy cathode portion and is in contact with the cathode auxiliary electrode, and
         the side surface of the main layer includes:
            a first junction portion in contact with a corresponding edge of the second common layers;
            a second junction portion in contact with a corresponding edge of the edges of the cathode electrodes; and
            a third junction portion in contact with the first sealing layer.
15. A method for manufacturing a display device, the method comprising:
   preparing a substrate;
   disposing a circuit layer on the substrate;
   disposing an element layer on the circuit layer; and
   disposing a sealing layer on the element layer,
   wherein the substrate includes a display area in which light emitting areas are arranged, and a non-display area disposed around the display area,
   the non-display area includes a junction area surrounding the display area, and
   the disposing of the sealing layer includes:
      disposing a first sealing layer including an inorganic insulating material on the element layer;
      disposing a second sealing layer including an organic insulating material on the first sealing layer;
      forming concave grooves recessed through at least a portion of the second sealing layer in a non-light emitting area between the light emitting areas; and
      disposing a third sealing layer covering the second sealing layer and the concave grooves and including an inorganic insulating material.
16. The method of clause 15, wherein the forming of the concave grooves includes:
   sequentially disposing a first mask material layer including a metal material and a second mask material layer including a photoresist material on the second sealing layer;
   forming a first mask layer including a first opening facing the junction area, first blocking portions arranged in the non-light emitting area, and a second blocking portion that is thicker than the first blocking portions in the non-light emitting area, by partially removing the second mask material layer;
   forming a second mask layer including a second opening by removing a portion of the first mask material layer exposed by the first opening;
   removing a portion of the second sealing layer exposed by the second opening;
   forming a third mask layer including third openings by removing the first blocking portions of the first mask layer;
   forming a fourth mask layer including fourth openings by removing a portion of the second mask layer exposed by the third openings;
   forming the concave grooves by partially removing the second sealing layer exposed by the fourth openings; and
   removing the third mask layer and the fourth mask layer.
17. The method of clause 16, wherein in the disposing of the element layer, the element layer includes:
   anode electrodes disposed in the light emitting areas;
   a pixel defining layer disposed in the non-light emitting area and covering edges of the anode electrodes;
   a cathode auxiliary electrode disposed on the pixel defining layer;
   first common layers disposed on the anode electrodes;
   light emitting layers disposed on the first common layers;
   second common layers disposed on the light emitting layers; and
   cathode electrodes disposed on the second common layers,
   wherein the cathode auxiliary electrode includes:
      a main layer; and
      a roof layer disposed on the main layer and including a metal material different from a material of the main layer, and
      wherein an undercut portion is defined by a bottom surface of the roof layer and a side surface of the man layer, overlaps a corresponding cathode electrode among the cathode electrodes and has a shape in which an edge of the roof layer more protrudes than the main layer.
18. The method of clause 17, wherein in the disposing of the element layer, the element layer further includes:
   a dummy common portion disposed on the pixel defining layer, including a same material as the second common layers and spaced apart from the second common layers by the undercut portion; and
   a dummy cathode portion covering the dummy common portion, including a same material as the cathode electrodes, and spaced apart from the cathode electrodes by the undercut portion,
   wherein the side surface of the main layer is in contact with a corresponding edge of the second common layers and a corresponding edge of the cathode electrodes, and
   in the disposing of the first sealing layer, the first sealing layer covers the cathode electrodes and the dummy cathode portion and is in contact with the side surface of the main layer of the cathode auxiliary electrode.
19. The method device of any of clauses 16 to 18, wherein in the forming of the concave grooves, at least some of the concave grooves are spaced apart from the first sealing layer.
20. The method of any of clauses 16 to 19, wherein in the forming of the concave grooves, at least some of the concave grooves penetrate the second sealing layer, and
   in the disposing of the third sealing layer, the third sealing layer is in contact with the first sealing layer through the at least some of the concave grooves and is in contact with the first sealing layer in the junction area.

## Claims

1. A display device comprising:
a substrate including a display area in which light emitting areas are arranged;
a circuit layer disposed on the substrate;
an element layer disposed on the circuit layer; and
a sealing layer disposed on the element layer,
wherein the sealing layer includes:
a first sealing layer disposed on the element layer and including an inorganic insulating material;
a second sealing layer disposed on the first sealing layer and including an organic insulating material;
concave grooves defined in a non-light emitting area between the light emitting areas and recessed through at least a portion of the second sealing layer; and
a third sealing layer covering the second sealing layer and the concave grooves and including an inorganic insulating material.

2. The display device of claim 1, wherein the element layer includes:
anode electrodes disposed in the light emitting areas;
a pixel defining layer disposed in the non-light emitting area and covering edges of the anode electrodes;
a cathode auxiliary electrode disposed on the pixel defining layer;
first common layers disposed on the anode electrodes;
light emitting layers disposed on the first common layers;
second common layers disposed on the light emitting layers; and
cathode electrodes disposed on the second common layers,
wherein the pixel defining layer includes an inorganic insulating material, and
edges of the cathode electrodes are in contact with the cathode auxiliary electrode.

3. The display device of claim 2, wherein the cathode auxiliary electrode includes:
a main layer; and
a roof layer disposed on the main layer and including a metal material different from a material of the main layer,
wherein an undercut portion is defined by a bottom surface of the roof layer and a side surface of the man layer, overlaps a corresponding cathode electrode among the cathode electrodes and has a shape in which an edge of the roof layer more protrudes than the main layer.

4. The display device of claim 3, wherein the element layer further includes:
a dummy common portion disposed on the pixel defining layer, including a same material as the second common layers, and spaced apart from the second common layers by the undercut portion; and
a dummy cathode portion covering the dummy common portion, including a same material as the cathode electrodes, and spaced apart from the cathode electrodes by the undercut portion, and
wherein the first sealing layer covers the cathode electrodes and the dummy cathode portion and is in contact with the cathode auxiliary electrode,
wherein the side surface of the main layer includes:
a first junction portion in contact with a corresponding edge of the second common layers;
a second junction portion in contact with a corresponding edge of the edges of the cathode electrodes; and
a third junction portion in contact with the first sealing layer.

5. The display device of claim 4, wherein the concave grooves overlap the dummy cathode portion, and
at least some of the concave grooves are spaced apart from the first sealing layer.

6. The display device of claim 4 or claim 5, wherein the concave grooves overlap the dummy cathode portion, and
at least some of the concave grooves penetrate the second sealing layer,
wherein the third sealing layer is in contact with the first sealing layer through the concave grooves.

7. The display device of any of claims 2 to 6, wherein each of the concave grooves extends in one of a first direction and a second direction in which the light emitting areas are arranged.

8. The display device of claim 7, wherein each of the concave grooves includes a bent shape in which first extension portions extending in a first diagonal direction intersecting the first direction and the second direction, and second extension portions extending in a second diagonal direction intersecting the first direction, the second direction, and the first diagonal direction are alternately arranged in the first direction or the second direction.

9. The display device of any of claims 2 to 8, wherein the concave grooves include first extension grooves and second extension grooves, which intersect each other.

10. The display device of any of claims 2 to 9, further comprising an overcoat layer disposed on the third sealing layer, including an organic insulating material, and filling the concave grooves.

11. An electronic device comprising:
a display device according to any preceding claim, the display device providing a screen,
wherein the display device includes:
a non-display area disposed around the display area;
wherein the non-display area includes a junction area surrounding the display area,
the second sealing layer is disposed in an area surrounded by the junction area, and
in the junction area, the third sealing layer is in contact with the first sealing layer.

12. A method for manufacturing a display device, the method comprising:
preparing a substrate;
disposing a circuit layer on the substrate;
disposing an element layer on the circuit layer; and
disposing a sealing layer on the element layer,
wherein the substrate includes a display area in which light emitting areas are arranged, and a non-display area disposed around the display area,
the non-display area includes a junction area surrounding the display area, and
the disposing of the sealing layer includes:
disposing a first sealing layer including an inorganic insulating material on the element layer;
disposing a second sealing layer including an organic insulating material on the first sealing layer;
forming concave grooves recessed through at least a portion of the second sealing layer in a non-light emitting area between the light emitting areas; and
disposing a third sealing layer covering the second sealing layer and the concave grooves and including an inorganic insulating material.

13. The method of claim 12, wherein the forming of the concave grooves includes:
sequentially disposing a first mask material layer including a metal material and a second mask material layer including a photoresist material on the second sealing layer;
forming a first mask layer including a first opening facing the junction area, first blocking portions arranged in the non-light emitting area, and a second blocking portion that is thicker than the first blocking portions in the non-light emitting area, by partially removing the second mask material layer;
forming a second mask layer including a second opening by removing a portion of the first mask material layer exposed by the first opening;
removing a portion of the second sealing layer exposed by the second opening;
forming a third mask layer including third openings by removing the first blocking portions of the first mask layer;
forming a fourth mask layer including fourth openings by removing a portion of the second mask layer exposed by the third openings;
forming the concave grooves by partially removing the second sealing layer exposed by the fourth openings; and
removing the third mask layer and the fourth mask layer.

14. The method of claim 13, wherein in the disposing of the element layer, the element layer is configured according to claim 2 or claim 4, and wherein the cathode auxiliary electrode is configured according to claim 3.

15. The method device of claim 13 or claim 14, wherein in the forming of the concave grooves, the concave grooves are configured according to any one of claims 5 to 9.
